# EUROPÄISCHE PATENTSCHRIFT

(11) **EP 2 476 171 B1**
(45) Veröffentlichungstag und Bekanntmachung des Hinweises auf die Patenterteilung: **04.12.2019**
(21) Anmeldenummer: 10752796.2
(22) Anmeldetag: 08.09.2010
(51) Int. Cl.: H01S 5/022, H01S 5/024, H01S 5/40

(54) **VERFAHREN ZUM THERMISCHEN KONTAKTIEREN EINANDER GEGENÜBERLIEGENDER ELEKTRISCHER ANSCHLÜSSE EINER HALBLEITERBAUELEMENT-ANORDNUNG**
METHOD OF THERMALLY CONTACTING OPPOSING ELECTRICAL CONNECTIONS OF A SEMICONDUCTOR ASSEMBLY
PROCÉDÉ POUR CONTACTER THERMIQUEMENT DE CONNEXIONS ÉLECTRIQUES OPPOSÉES DANS UN ENSEMBLE À SEMICONDUCTEUR

(30) Priorität: 09.09.2009 DE 102009040835
(43) Veröffentlichungstag der Anmeldung: 18.07.2012
(73) Patentinhaber: JENOPTIK Optical Systems GmbH, 07745 Jena (DE)
(72) Erfinder: SCHRÖDER, Matthias, 07646 Stadtroda (DE); SCHRÖDER, Dominic, 48231 Warendorf (DE); HENNIG, Petra, 07646 Mörsdorf (DE)
(74) Vertreter: Waldauf, Alexander
(86) Internationale Anmeldenummer: PCT/EP2010/063174
(87) Internationale Veröffentlichungsnummer: WO 2011/029846

(56) Entgegenhaltungen:
- GB-A- 1 083 200
- JP-A- 52 020 782
- US-A- 3 351 698
- US-A1- 2002 181 523
- US-A1- 2008 056 314
- US-B1- 6 448 642
- PITTROFF W ET AL: "Mounting of laser bars on copper heat sinks using Au/Sn solder and CuW submounts", 2002 PROCEEDINGS 52ND. ELECTRONIC COMPONENTS AND TECHNOLOGY CONFERENCE. ECTC 2002. SAN DIEGO, CA, MAY 28 - 31, 2002; [PROCEEDINGS OF THE ELECTRONIC COMPONENTS AND TECHNOLOGY CONFERENCE], NEW YORK, NY : IEEE, US LNKD- DOI:10.1109/ECTC.2002.1008107, Bd. CONF. 52, 28. Mai 2002 (2002-05-28), Seiten 276-281, XP010747640, ISBN: 978-0-7803-7430-0

## Beschreibung

Die Erfindung betrifft ein Verfahren zur Herstellung eines Halbleitermoduls, beispielsweise eines Diodenlaserbauelementes, bei dem die elektrischen Anschlüsse einer Halbleiterbauelement-Anordnung, beispielsweise eines Laserdiodenbarrens, thermisch Kontaktiert werden.

Aus der Publikation der Proceedings of SPIE 6104-04 (2006) "Comparative performance studies of indium and gold-tin packaged diode laser bars" von Dirk Lorenzen et. al. ist ein Verfahren zur beidseitigen thermischen und elektrischen Kontaktierung eine Laserdiodenbarrens bekannt, bei dem jeweils ein als Kühlkörper ausgebildeter elektrisch leitfähiger Wärmeleitkörper aus Kupfer mittels eines Indium-Lotes an einander gegenüberliegende elektrische Kontaktflächen des Laserdiodenbarrens gelötet sind.

Vorteilhaft an diesem Verfahren ist die geringe Anzahl der Komponenten die zur Herstellung des Diodenlaserbauelementes nötig sind. Vorteilhaft ist außerdem die Verwendung eines kostengünstigen und hoch wärmeleitfähigen Wärmeleitkörpermaterials. Nachteilig an diesem Verfahren ist die mechanische Spannung, die durch das thermisch vorteilhafte Kupfer durch Abkühlung von der Verfestigungstemperatur des Lotes (157°C) auf Raumtemperatur in den Laserdiodenbarren eingebracht wird und dessen optische Eigenschaften negativ beeinflusst.

Aus der Offenlegungsschrift EP 1 341 275 A2 ist ein weiteres Verfahren zur thermischen Kontaktierung von elektrischen Anschlüssen eines Laserdiodenbarrens bekannt, dass die Aufgabe einer mechanisch spannungsarmen Kontaktierung des Laserdiodenbarrens dadurch löst, dass der Laserdiodenbarren unter Verzicht auf Lotschichten beidseitig kraftschlüssig durch jeweils einen elektrisch leitfähigen Wärmeleitkörper sowohl elektrisch als auch thermisch kontaktiert werden.

Vorteilhaft an diesem Verfahren und der mit diesem Verfahren herstellten Anordnung ist die gegenüber einer Lötverbindung mit thermisch gegenüber dem Laserdiodenbarren ausdehnungsfehlangepassten Wärmeleitkörpern niedrige mechanische Spannung, die eine hohe Leistungshomogenität der optischen Strahlung von Emittern eines Laserdiodenbarrens sichert.

Nachteilig an diesem Verfahren ist die unzureichende thermische Kontaktierung des Laserdiodenbarrens, die sich in einer zu geringen elektro-optischen Konversionseffizienz und einer zu niedrigen optischen Maximalleistung manifestiert.

Nachteilig an diesem Verfahren ist überdies das Erfordernis von Befestigungsmitteln, die zur Gewährleistung der kraftschlüssigen Verbindung nicht nur zur Verbindungsbildung, sondern auch zur Aufrechterhaltung der kraftschlüssigen Verbindung vorgesehen sind und im Diodenlaserbauelement verbleiben müssen.

Die Offenlegungsschrift US3351698 offenbart das Herstellungsverfahren eines Halbleitermoduls durch: Bereitstellen einer Halbleiterdiode mit einer ersten und einer zweiten Kontaktfläche und eines ersten und eines zweiten Wärmeleitkörpers mit jeweils einem Kontaktabschnitt und einem Verbindungsabschnitt. Eine Kraft, die von einem der beiden Wärmeleitkörper in Richtung des anderen orientiert ist, wird durch Kühlung auf 77° erzeugt und hält kurzzeitig eine elektrische Verbindung zwischen den Wärmeleitkörpern und der Halbleiterdiode aufrecht.

Aufgabe der Erfindung ist es, ein Verfahren zur thermischen Kontaktierung der elektrischen Anschlüsse eines Laserdiodenbarrens zu beschreiben, das die vorgenannten Nachteile nicht aufweist.

Diese Aufgabe wird gelöst durch ein Verfahren zum Herstellen eines Halbleitermoduls nach Anspruch 1. Weiterbildungen des erfindungsgemäßen Verfahrens sind Gegenstand der Unteransprüche.

Erfindungsgemäß werden in einem ersten Verfahrensschritt die für erfindungsgemäße Herstellung des Halbleitermoduls essentiellen Komponenten mit den erfindungsspezifischen Merkmalen bereitgestellt. Zu diesen zählen (i) eine Halbleiterbauelement-Anordnung, die auf einer ersten Seite wenigstens einen ersten elektrischen Anschluss mit einer ersten Kontaktfläche aufweist und auf einer der ersten Seite gegenüberliegenden zweiten Seite wenigstens einen zweiten elektrischen Anschluss mit einer zweiten Kontaktfläche aufweist, (ii) ein erster Wärmeleitkörper, (iii) wenigstens ein zweiter Wärmeleitkörper, (iv) eine erste metallische Schicht, (v) wenigstens eine zweite metallische Schicht und (vi) wenigstens ein Fügemittel.

Bei der Halbleiterbauelement-Anordnung kann es sich im einfachsten Fall um ein einzelnes Halbleiterbauelement, beispielsweise ein Laserdiodenelement, handeln, wobei die elektrischen Anschlüsse durch wenigstens eine erste elektrisch leitfähige Kontaktschicht - beispielsweise eine erste Metallisierung - auf der ersten Seite des Halbleiterbauelementes und wenigstens eine zweite elektrisch leitfähige Kontaktschicht - beispielsweise eine zweite Metallisierung - auf der zweiten Seite des Halbleiterbauelementes gebildet sind und die erste Kontaktfläche auf der von dem Halbleiterbauelement abgewandten Seite der ersten elektrisch leitfähigen Kontaktschicht angeordnet ist und die zweite Kontaktfläche auf der von dem Halbleiterbauelement abgewandten Seite der zweiten elektrisch leitfähigen Kontaktschicht angeordnet ist. Zu erfindungsgemäßen Laserdiodenelementen zählen Laserdioden mit einem einzigen Emitter, Laserdioden mit mehreren nebeneinander und/ oder übereinander angeordneten Emittern und Laserdiodenbarren mit einer Vielzahl in Reihe nebeneinander angeordneter Emitter.

Alternativ kann die Halbleiterbauelement-Anordnung als Unterbaugruppe eines Halbleitermoduls - beispielsweise als Diodenlaser-Unterbaugruppe - ausgebildet sein, indem sie wenigstens ein Halbleiterbauelement, beispielsweise ein oder mehrere Laserdiodenelemente, aufweist sowie einen ersten elektrisch leitfähiger Kontaktkörper, der den ersten elektrischen Anschluss bereitstellt und einen zweiten elektrisch leitfähigen Kontaktkörper, der den zweiten elektrischen Anschluss bereitstellt. Dabei ist der erste elektrisch leitfähige Kontaktkörper mittels eines ersten elektrisch leitfähigen Fügemittels stoffschlüssig an einer ersten Seite des Halbleiterbauelementes befestigt und der zweite elektrisch leitfähige Kontaktkörper mittels eines zweiten elektrisch leitfähigen Fügemittels stoffschlüssig an einer der ersten Seite des Halbleiterbauelementes gegenüberliegenden zweiten Seite des Halbleiterbauelementes befestigt, wobei die erste Kontaktfläche auf der von dem Halbleiterbauelement abgewandten Seite des ersten elektrisch leitfähigen Kontaktkörpers angeordnet ist und die zweite Kontaktfläche auf der vom Halbleiterbauelement abgewandten Seite des zweiten elektrisch leitfähigen Kontaktkörpers angeordnet ist. Selbstverständlich sind erfindungsgemäß auch Unterbaugruppen mit nur einem Kontaktkörper denkbar und für die Ausführung des erfindungsgemäßen Verfahrens nutzbar.

Die elektrische Leitfähigkeit der Kontaktkörper kann durch ein elektrisch leitfähiges Material eines Kernkörpers des Kontaktkörpers bereitgestellt werden oder durch eine elektrisch leitfähige Schicht auf einem elektrisch isolierenden Kernkörper, beispielsweise einem Kernkörper aus elektrisch isolierendem Material.

Während im Falle der Ausbildung der Halbleiterbauelement-Anordnung als Halbleiterbauelement die erste Kontaktfläche als erste elektrische Kontaktfläche zur ersten elektrischen und thermischen Kontaktierung des Halbleiterbauelementes vorgesehen ist und die zweite Kontaktfläche als zweite elektrische Kontaktfläche zur zweiten elektrischen und thermischen Kontaktierung des Halbleiterbauelementes, ist im Falle der Ausbildung der Halbleiterbauelement-Anordnung als Unterbaugruppe eines Halbeitermoduls die erste Kontaktfläche des ersten Kontaktkörpers prinzipiell zunächst als erste thermische Kontaktfläche zur ersten thermischen Kontaktierung der Unterbaugruppe - verbunden jedoch mit der möglichen Option zur elektrischen Kontaktierung derselben - vorgesehen und die zweite Kontaktfläche des zweiten Kontaktkörpers prinzipiell zunächst als zweite thermische Kontaktfläche zur zweiten thermischen Kontaktierung der Unterbaugruppe - verbunden jedoch mit der möglichen Option zur elektrischen Kontaktierung derselben.

Vorzugsweise besitzen die elektrisch leitfähigen Kontaktkörper einen thermischen Ausdehnungskoeffizienten, der um nicht mehr als 2 ppm/ K von dem des Halbleiterbauelementes abweicht. Dies wird für Halbleiterbauelemente, die hinsichtlich Gewichts- Atom- und/ oder Volumenanteilen überwiegend aus Galliumarsenid, Indiumphosphid, Galliumnitrid, Zinkoxid oder Silizium bestehen, möglich, wenn die elektrisch leitfähigen Kontaktkörper Wolfram, Molybdän, Kohlenstoff, Bornitrid und/ oder Siliziumkarbid enthalten, gegebenenfalls in Verbindung mit einem Metall eines höheren Ausdehnungsdehnungskoeffizienten, beispielsweise Kupfer, Silber oder Aluminium. In dieser Weise bezüglich des Halbleiterbauelementes ausdehnungsangepasste elektrisch leitfähige Kontaktkörper gestatten die stoffschlüssige spannungsarme Kontaktierung des Halbleiterbauelementes durch die elektrisch leitfähigen Kontaktkörper unter Verwendung eines zuverlässigen Hartlotes, beispielsweise eines Gold-Zinn-Lotes.

Aus Kostengründen nehmen die elektrisch leitfähigen Kontaktkörper jedoch keine für die nötige Wärmespreizung ausreichende Größe in einem Halbleitermodul ein. Hersteller beziehungsweise Anwender werden daher vorzugsweise, hinsichtlich ihres Volumens größere, Wärmeleitkörper an die elektrisch leitfähigen Kontaktkörper im Speziellen beziehungsweise die Halbleiterbauelement-Anordnung im Allgemeinen anbringen.

Vorzugsweise ist dabei der erste Wärmeleitkörper in wenigstens einer seiner Erstreckungsrichtungen größer als die Halbleiterbauelement-Anordnung in einer ihrer Erstreckungsrichtungen parallel zur ersten und/ oder zweiten Kontaktfläche; ebenso ist vorzugsweise der zweite Wärmeleitkörper in wenigstens einer seiner Erstreckungsrichtungen größer als die Halbleiterbauelement-Anordnung in einer ihrer Erstreckungsrichtungen parallel zur ersten und/ oder zweiten Kontaktfläche.

Zur Vorbereitung der thermischen Kontaktierung der Halbleiterbauelement-Anordnung mit den Wärmeleitkörpern wird im zweiten erfindungsgemäßen Verfahrensschritt die Halbleiterbauelement-Anordnung in der Weise zwischen dem ersten und dem zweiten Wärmeleitkörper angeordnet, dass ein erster Kontaktabschnitt des ersten Wärmeleitkörpers der ersten Kontaktfläche gegenüberliegt, ein zweiter Kontaktabschnitt des zweiten Wärmeleitkörpers der zweiten Kontaktfläche gegenüberliegt. Erfindungsgemäß weisen der erste Wärmeleitkörper einen ersten Verbindungsabschnitt und der zweite Wärmeleitkörper einen zweiten Verbindungsabschnitt auf, wobei der erste Verbindungsabschnitt des ersten Wärmeleitkörpers dem zweiten Verbindungsabschnitt des zweiten Wärmeleitkörpers abseits der Halbleiterbauelement-Anordnung gegenüberliegt. Erfindungsgemäß ist die erste metallische Schicht zumindest abschnittsweise zwischen dem ersten Kontaktabschnitt und der ersten Kontaktfläche angeordnet und die zweite metallische Schicht zumindest abschnittsweise zwischen dem zweiten Kontaktabschnitt und der zweiten Kontaktfläche.

Abseits der Halbleiterbauelement-Anordnung ist so zu verstehen, dass damit der Bereich außerhalb der zu den Kontaktflächen senkrechten Projektion der Halbleiterbauelement-Anordnung gemeint ist. Insofern liegen die Kontaktabschnitte der Wärmeleitkörper nicht abseits der Halbleiterbauelement-Anordnung. Dabei kann im ersten oder zweiten Verfahrensschritt die erste metallische Schicht auf die erste Kontaktfläche oder eine der Halbleiterbauelement-Anordnung zugewandten erste Wärmeeintrittsfläche des ersten Kontaktabschnitts aufgebracht werden und/ oder die zweite metallische Schicht auf die zweite Kontaktfläche oder eine der Halbleiterbauelement-Anordnung zugewandten zweite Wärmeeintrittsfläche des zweiten Kontaktabschnitts aufgebracht werden. Dieses Aufbringen kann durch Abscheiden aus der Gasphase (Bedampfen, Aufsputtern, CVD), durch galvanische Abscheidung aus einem Elektrolyten usw. erreicht werden.

Überdies ist es möglich, jeweils beide Flächen, das heißt sowohl jeweils die Kontaktfläche als auch die Wärmeeintrittsfläche, mit einer oder mehreren metallischen Schichten zu versehen.

Alternativ oder optional können die erste und die zweite metallische Schicht auch körperlich individuell als Folien oder Platten, beispielsweise als so genannte preforms, vorliegen.

Im dritten erfindungsgemäßen Verfahrensschritt wird wenigstens eine Kraft erzeugt, die zumindest komponentenweise effektiv von einem der beiden Wärmeleitkörper in Richtung des anderen Wärmeleitkörpers orientiert ist.

Vorzugsweise wird eine solche Kraft als äußere Kraft von außen auf wenigstens einen der beiden Wärmeleitkörper aufgebracht, so dass sie zumindest komponentenweise in Richtung des anderen Wärmeleitkörpers orientiert ist. Möglich ist jedoch auch die Erzeugung einer inneren Kraft, die beispielsweise durch Schrumpfen eines zwischen die Wärmeleitkörper eingebrachten Fügemittelvolumens hervorgerufen wird. Die erfindungsgemäße Kraft übt damit einen Druck auf die Halbleiterbauelement-Anordnung, die erste metallische Schicht und die zweite metallische Schicht aus. Sie kann als äußere Kraft zum Beispiel einseitig in zu der ersten Kontaktfläche senkrechter Richtung auf die der Halbleiterbauelement-Anordnung abgewandten Seite des ersten Wärmeleitkörper aufgebracht werden, während der zweite Wärmeleitkörper mit seiner der Halbleiterbauelement-Anordnung abgewandten Seite auf einer Stützfläche aufliegt. Umgekehrt kann eine äußere Kraft auch einseitig in zu der zweiten Kontaktfläche senkrechter Richtung auf die der Halbleiterbauelement-Anordnung abgewandten Seite des zweiten Wärmeleitkörper aufgebracht werden, während der erste Wärmeleitkörper mit seiner der Halbleiterbauelement-Anordnung abgewandten Seite auf einer Stützfläche aufliegt. Ferner können zwei gleich große einander entgegengerichtete äußere Kräfte auf die der Halbleiterbauelement-Anordnung abgewandten Außenseiten des ersten und zweiten Wärmeleitkörpers aufgebracht werden, die sich zum Ausübung eines Druckes auf die Halbleiterbauelement-Anordnung, die erste metallische Schicht und die zweite metallische Schicht addieren. Typische erfindungsgemäße Kräfte liegen im Bereich von 0,1 N bis 1kN und können während des Verfahrens variieren.

Überdies wird im dritten erfindungsgemäßen Verfahrensschritt ein stoffschlüssiges Verbinden der beiden Wärmeleitkörper durch eine Verfestigung des Fügemittels erreicht. Erfindungsgemäß ist das Fügemittel explizit an der Verbindungsbildung beteiligt - sprich: für die Einrichtung der stoffschlüssigen Verbindung der beiden Wärmeleitkörper unerlässlich. Erfindungsgemäß ist das Fügemittel zumindest abschnittsweise zwischen dem ersten und dem zweiten Verbindungsabschnitt angeordnet.

Dabei kann das Fügemittel bereits im zweiten Verfahrensschritt zwischen den ersten und zweiten Verbindungsabschnitt eingebracht sein, dass heißt: bevor der erfindungsgemäße Druck auf einen oder beide Wärmeleitkörper aufgebracht wurde. Es kann aber auch erst im dritten Verfahrensschritt zwischen den ersten und zweiten Verbindungsabschnitt eingebracht werden, wobei der erfindungsgemäße Druck bereits vor dem Einbringen vorliegt und während des Einbringens zumindest qualitativ erhalten bleibt.

Das Fügemittel kann vor der Verfestigung in flüssiger, pastöser oder fester Form vorliegen. Liegt es in fester Form vor, so wird es zur Erzielung einer Benetzung des ersten und/ oder zweiten Verbindungsabschnittes vorzugsweise durch Einwirken von Kraft oder Wärme aufgrund physikalischer und/ oder chemischer Effekte in einen flüssigen oder pastösen Zustand versetzt, aus dem es sich unter Beibehaltung oder nach Aufheben der besagten Kraft oder Wärme wieder verfestigt.

Das Fügemittel zeichnet sich vorzugsweise im verfestigten Zustand dadurch aus, dass es von geringer Flexibilität und hoher Biegesteifigkeit ist, so dass es inneren Scher- und Schälkräften gegenüber rissfest bleibt und entsprechend hohe Scher- und Schälspannungen aufnehmen kann.

Zu derartigen Fügemitteln zählen beispielsweise duroplastische - beispielsweise epoxidhaltige - Klebstoffe, metallische Lote, Glaslote und Zemente.

Insbesondere eines der genannten Fügemittel ist im verfestigten Zustand somit in der Lage einen Kraftschluss zwischen dem zweiten Kontaktabschnitt und der zweiten Kontaktfläche aufrechtzuerhalten, so dass auch nach Aufheben der äußeren Kraft in einem weiteren, optionalen Verfahrensschritt ein ausreichender thermischer Kontakt zwischen dem zweiten Kontaktabschnitt und der zweiten Kontaktfläche verbleibt.

Erfindungswesentlich an dem dritten Verfahrensschritt ist das Merkmal, dass keines der metallischen Materialien der zweiten metallischen Schicht während des Aufbringens und/ oder Aufrechterhaltens der äußeren Kraft und/ oder der Verfestigung des Fügemittels aufschmilzt. Das bedeutet, dass die Temperatur in der zweiten metallischen Schicht im dritten Verfahrensschritt nicht die Schmelztemperatur desjenigen metallischen Materials der zweiten metallischen Schicht mit der niedrigsten Schmelztemperatur überschreitet.

Für den Fall der Ausbildung einer stoffschlüssigen Verbindung zwischen dem zweiten Kontaktabschnitt und der Halbleiterbauelement-Anordnung bedeutet dies, dass sie durch Festkörper-Diffusion wenigstens eines metallischen Materials der zweiten metallischen Schicht in einen metallischen Oberflächenbereich des zweiten Kontaktabschnittes und/ oder des zweiten elektrischen Anschlusses und/ oder durch Festkörper-Diffusion von wenigstens einem metallischen Material des Oberflächenbereiches des zweiten Kontaktabschnittes und/ oder des zweiten elektrischen Anschlusses in die zweite metallische Schicht erfolgt, ohne dass eines der metallischen Materialien der zweiten metallischen Schicht, des Oberflächenbereiches des zweiten Kontaktabschnittes oder des zweiten elektrischen Anschlusses, eine seiner gebildeten Verbindungen oder eine ihrer gebildeten Mischungen untereinander oder mit einer oder mehrerer seiner gebildeten Verbindungen in einen flüssigen Zustand übergeht. Als Beispiele solcher Verbindungen sind intermetallische Phasen zu nennen, als Beispiele solcher Mischungen Eutektika aus den Metallen und/ oder ihrer intermetallischen Phasen.

Das erfindungsgemäße Kontaktierungsverfahren stellt somit im Prinzip eine "durch abseitigen Stoffschluss aufrechterhaltene metallschichtunterstützte Klemmung" dar, auf die im folgenden unter dem Kurzbegriff "Klemmung" Bezug genommen wird und die sich von einer Lötung nach dem Stand der Technik dadurch unterschiedet, dass die an der Verbindungsbildung beteiligte Metallschicht im Falle der Lötung aufschmilzt, im Falle der erfindungsgemäßen Klemmung jedoch nicht.

Vorteilhaft an der Erfindung ist der Umstand, dass die Temperatur in der zweiten metallischen Schicht und damit auch die Temperatur der zu verbindenden Komponenten bei Bildung der kraft- oder stoffschlüssigen Verbindung unter Beteiligung der zweiten metallischen Schicht niedriger als im Falle eines Lötverfahrens ist, bei dem das Lotgut in den flüssigen Zustand wechselt und bei einer Verfestigungstemperatur, die höher ist als die erfindungsgemäß zulässige Temperatur, erstarrt. Dadurch ist die Temperaturdifferenz, die für einen Spannungseintrag bei Abkühlung durch die unterschiedlichen thermischen Ausdehnungskoeffizienten nach Ausbildung der Verbindung wirksam wird, erfindungsgemäß geringer als bei einer Lötung nach dem Stand der Technik. Bei Verwendung von Wärmeleitkörpern eines höheren thermischen Ausdehnungskoeffizienten als dem der Halbleiterbauelement-Anordnung ist die mit dem erfindungsgemäßen Verfahren eingebrachte Druckspannung in lateraler Richtung, das heißt in der größten Erstreckungsrichtung der Halbleiterbauelement-Anordnung parallel zu der ersten und/ oder zweiten Kontaktfläche, vorteilhaft wesentlich geringer als im Falle einer Lötung.

Bei Anwendung des erfindungsgemäßen Verfahrens auf einen Laserdiodenbarren haben die Erfinder überraschenderweise festgestellt, dass bei Auswahl der entsprechenden Materialien und Prozessparameter nur eine vergleichbare elektro-optische Konversionseffizienz gegenüber dem hausüblichen Lötverfahren erzielbar waren (siehe erstes Ausführungsbeispiel).

Obwohl die zur thermischen Kontaktierung verwendete zweite Metallschicht nicht aufschmolz ließ sich eine thermische Kontaktierung des Laserbarrens erreichen, die prinzipiell derjenigen des Falles gleichkommt, in dem die zweite Metallschicht in einem Lötprozess aufschmolz.

Darüber hinaus wurde überraschenderweise festgestellt, dass die durch Klemmung eingebrachte Druckspannung in transversaler, das heißt in zu der ersten und/ oder zweiten Kontaktfläche senkrechter, Richtung kaum einen negativen Einfluss auf die optische Eigenschaft der emittierten Strahlung des Laserdiodenbarrens hat. Im Gegenteil ist der Leistungshomogenität im Falle der Klemmung deutlich homogener als im Falle der Lötung über die Emitter des Laserdiodenbarrens verteilt (siehe erstes Ausführungsbeispiel).

Vorteilhaft an der erfindungsgemäßen Klemmung wirkt sich außerdem aus, dass der durch das Fügemittel - beispielsweise zwischen den beiden Verbindungsabschnitten - vermittelte Stoffschluss eine nicht wieder aufhebbare stützende Wirkung auf die thermische Verbindung zwischen dem zweiten Wärmeleitkörper und der Halbleiterbauelement-Anordnung ausübt, was einerseits für die kraftschlüssige Klemmung unerlässlich ist und andererseits den schwach ausgebildeten Stoffschluss der stoffschlüssigen Klemmung vor schädlicher Schälbelastung schont.

Des weiteren macht der besagte Stoffschluss die Verwendung von kraftschlüssigen Verbindungs- und/ oder Befestigungsmitteln obsolet, was sich einer reduzierten Baugröße und reduzierten Kosten des Halbleitermoduls niederschlägt.

Insgesamt besteht der wesentliche Vorteil der Erfindung darin, insbesondere mit kostengünstigen, hoch wärmeleitfähigen Wärmeleitkörpern aus Kupfer und/ oder Aluminium, trotz ihres gegenüber der Halbleiterbauelement-Anordnung stark abweichenden thermischen Ausdehnungskoeffizienten eine gute und zuverlässige thermische Kontaktierung der Halbleiterbauelement-Anordnung zu erzielen, die außerdem im Falle von Laserdiodenelementen sehr homogene optische Eigenschaften der Strahlung einzelner Emitter eines Laserdiodenbarrens gewährleisten.

Dabei kann sehr wohl im erfindungswesentlichen dritten Verfahrensschritt eine Erhöhung der Temperatur des Fügemittels vorgesehen sein, die sich auch auf die Temperatur der zweiten metallischen Schicht auswirkt, beispielsweise um eine Verflüssigung und/ oder eine Verfestigung des Fügemittels zu erreichen. Dennoch bleibt die Temperatur in der zweiten Schicht während der Prozessierung des Fügemittels erfindungsgemäß unterhalb des Schmelzpunktes jedes ihrer Konstituenten. Selbst wenn die Temperatur im Fügemittel über längere Zeit, beispielsweise 1 Sekunde bis 10 Minuten, höher ist als die niedrigste Schmelztemperatur eines Materials der zweiten Schicht, lässt sich durch eine Kühlung der zweiten Schicht ein stationärer Temperaturgradient zwischen dem Fügemittel und der zweiten Schicht etablieren, der in der zweiten Schicht unterhalb des niedrigsten Schmelzpunktes eines ihrer Materialien liegt. Ohne eine solche Kühlung lässt sich die Temperatur im Fügemittel über eine kürzere Zeit, beispielsweise 1 Millisekunde bis 1 Sekunde, höher als die niedrigste Schmelztemperatur eines Materials der zweiten Schicht aufrechterhalten, wenn der durch die zeitlich verzögerte Wärmediffusion ausgebildete instationäre Temperaturgradient zu keiner Zeit in keinem Bereich der zweiten Schicht eine Temperatur aufweist, die höher ist als der Schmelzpunkt des betreffenden Bereiches.

Im Übrigen kann es vorteilhaft sein, wenn die Temperatur der zweiten Schicht im dritten Verfahrensschritt zumindest zeitweise über Raumtemperatur liegt. Da sich die Festigkeitseigenschaften der meisten Materialien mit Erhöhung der Temperatur erniedrigen, kann im Falle der Ausbildung einer kraftschlüssigen Verbindung zwischen dem zweiten Kontaktabschnitt und der zweiten Kontaktfläche der thermische Kontakt zwischen ihnen durch erhöhte plastische Deformation der zweiten Schicht verbessert werden. Ähnlich verhält es sich im Falle der Ausbildung einer stoffschlüssigen Verbindung zwischen dem zweiten Kontaktabschnitt und der Halbleiterbauelement-Anordnung durch Festkörper-Diffusion. Der das Diffusionsverhalten der Diffusion eines ersten Stoffes in einen zweiten Stoff bestimmende Diffusionskoeffzient weist eine dem Arrhenius'schen Gesetz ähnliches Verhalten auf, gemäß dessen sich die Diffusion bei erhöhter Temperatur erhöht und/ oder beschleunigt. Damit wird ein thermischer Kontakt auch bei der Ausbildung einer stoffschlüssigen Verbindung bei Temperaturerhöhung verbessert.

Zur Verbesserung der Benetzung von Materialien der zweiten metallischen Schicht auf der zweiten Kontaktfläche der Halbleiterbauelement-Anordnung oder auf der der zweiten Kontaktfläche gegenüberliegenden Wärmeeintrittsfläche des zweiten Kontaktabschitts sollte wenigstens der dritte Verfahrensschritt vorzugsweise im Vakuum oder in einer bezüglich des metallischen Materials der ersten und/ oder zweiten metallischen Schicht chemisch inerten oder reduzierenden Atmosphäre erfolgen. Wird eine Beschichtung der Halbleiterbauelement-Anordnung oder der Wärmeleitkörper mit der metallischen Schicht in Vakuum vorgenommen, so ist vorzugsweise auch die Anordnung der Komponenten zueinander im zweiten Verfahrensabschnitt unter diesem Vakuum durchzuführen, ohne nach der Beschichtung einen Kontakt der Beschichtung mit der Umgebungsatmosphäre zuzulassen.

Für die Ausbildung eines Stoffschlusses zwischen der zweiten metallischen Schicht und der Halbleiterbauelement-Anordnung und/ oder zwischen der zweiten metallischen Schicht und dem zweiten Kontaktabschnitt, ist es zu bevorzugen, dass die zweite Kontaktfläche und/ oder die Wärmeeintrittsfläche eine diffusionsfreudige metallische Oberflächenbeschichtung, beispielsweise die eines Edelmetalls aufweisen. Vorzugsweise ist diese Diffusionsschicht eine Goldschicht, deren Dicke vorzugsweise im Bereich von 50nm bis 1µm liegt. Eine darunter liegende Diffusionsbarriere, beispielsweise eine Schicht Nickel, Palladium, Platin oder Refraktärmetall ist erfindungsgemäß nicht nötig, kann aber vorgesehen werden, beispielsweise um die Haftfestigkeit der Diffusionsschicht auf der Halbleiterbauelement-Anordnung beziehungsweise dem zweiten Kontaktabschnitt zu verbessern.

Erfindungsgemäß unterliegt wenigstens die thermische Kontaktierung der zweiten Seite der Halbleiterbauelement-Anordnung der durch abseitigen Stoffschluss aufrechterhaltenen metallschichtunterstützten Klemmung.

Die erste Seite der Halbleiterbauelement-Anordnung kann durch eine herkömmliche Lötung kontaktiert sein, insbesondere wenn es sich um die Seite der Halbleiterbauelement-Anordnung handelt, auf der im Betrieb des Halbleitermoduls der überwiegende Wärmeanteil produziert wird. Im Falle eines Laserdiodenelementes ist dies die Epitaxieseite der Halbleiterbauelement-Anordnung, wobei die zweite Seite der Substratseite entspricht. Epitaxieseitig wird zumeist eine höhere Anforderung an die thermische, elektrische und mechanische Zuverlässigkeit an die thermische und vorzugsweise damit einhergehende elektrische Kontaktierung gestellt, die beispielsweise durch ein Gold-Zinn-Hartlot erfüllt werden kann unter der Voraussetzung, dass der thermische Ausdehnungskoeffizient des ersten Wärmeleitkörpers um nicht mehr als vorzugsweise 2 ppm/K von dem der Halbleiterbauelement-Anordnung abweicht. Vorzugsweise besteht ein solcher erster Wärmeleitkörper hinsichtlich Gewichts-/ Atom- und/ oder Volumenanteilen überwiegend aus einem metallhaltigen Verbundwerkstoff, beispielsweise einem Diamant-Silber-Verbundwerkstoff.

Andererseits kann auch die erste Seite der Halbleiterbauelement-Anordnung analog und zusätzlich zur zweiten Seite durch eine durch abseitigen Stoffschluss aufrechterhaltenen metallschichtunterstützten Klemmung thermisch kontaktiert sein, wobei im dritten Verfahrensschritt die Temperatur in der ersten und der zweiten metallischen Schicht vorzugsweise nicht die Schmelztemperaturen derjenigen Materialien in den jeweiligen Schichten mit den jeweils niedrigsten Schmelztemperaturen überschreitet.

Dabei kann im dritten Verfahrensschritt die Ausbildung einer kraftschlüssigen Verbindung zwischen dem zweiten Kontaktabschnitt und der zweiten Kontaktfläche und die Ausbildung einer kraftschlüssigen Verbindung zwischen dem ersten Kontaktabschnitt und der ersten Kontaktfläche erfolgen, die durch das verfestigte Fügemittel zwischen dem ersten und dem zweiten Verbindungsabschnitt aufrechterhalten werden.

Andererseits kann im dritten Verfahrensschritt die Ausbildung einer stoffschlüssigen Verbindung zwischen dem zweiten Kontaktabschnitt und der Halbleiterbauelement-Anordnung durch Festkörper-Diffusion wenigstens eines metallischen Materials der zweiten metallischen Schicht in einen metallischen Oberflächenbereich des zweiten Kontaktabschnittes und/ oder des zweiten elektrischen Anschlusses und/ oder durch Festkörper-Diffusion von wenigstens einem metallischen Material des Oberflächenbereiches des zweiten Kontaktabschnittes und/ oder des zweiten elektrischen Anschlusses in die zweite metallische Schicht erfolgen, ohne dass eines der metallischen Materialien der zweiten metallischen Schicht, des Oberflächenbereiches des zweiten Kontaktabschnittes oder des zweiten elektrischen Anschlusses, eine seiner gebildeten Verbindungen oder eine ihrer gebildeten Mischungen untereinander oder mit einer oder mehrerer seiner gebildeten Verbindungen in einen flüssigen Zustand übergeht und
die Ausbildung einer stoffschlüssigen Verbindung zwischen dem ersten Kontaktabschnitt und der Halbleiterbauelement-Anordnung durch Festkörper-Diffusion wenigstens eines metallischen Materials der ersten metallischen Schicht in einen metallischen Oberflächenbereich des ersten Kontaktabschnittes und/ oder des ersten elektrischen Anschlusses und/ oder durch Festkörper-Diffusion von wenigstens einem metallischen Material des Oberflächenbereiches des ersten Kontaktabschnittes und/ oder des ersten elektrischen Anschlusses in die erste metallische Schicht erfolgen, ohne dass eines der metallischen Materialien der ersten metallischen Schicht, des Oberflächenbereiches des ersten Kontaktabschnittes oder des ersten elektrischen Anschlusses, eine seiner gebildeten Verbindungen oder eine ihrer gebildeten Mischungen untereinander oder mit einer oder mehrerer seiner gebildeten Verbindungen in einen flüssigen Zustand übergeht.

Zur Ausbildung der stoffschlüssigen Verbindung ist die Benetzung der Fügepartner durch ein oder vorzugsweise das Material der ersten beziehungsweise zweiten Schicht eine Bedingung. Die Diffusionsfreudigkeit der Materialien der benetzenden Oberfläche unterstützt den Prozess der Ausbildung der stoffschlüssigen Verbindung zusätzlich. Hervorragende Benetzungspartner sind Edelmetalle und relativ weiche, niederschmelzende Metalle. Vorzugsweise enthalten daher die erste und/ oder zweite Schicht wenigstens ein Material mit einem chemisches Element aus der Gruppe Indium, Zinn, Blei und Cadmium. Dieses Material kann einerseits allein aus einem der besagten chemischen Elemente bestehen, insbesondere kann die erste und/ oder zweite metallische Schicht hinsichtlich Gewichts- Atom- und/ oder Volumenanteilen überwiegend oder vollständig aus Zinn, Blei, Cadmium oder - besonders bevorzugt - Indium bestehen. Andererseits kann das Material aus eutektischen Mischungen der besagten chemischen Elemente mit anderen chemischen Elementen oder den genannten chemischen Elementen bestehen, insbesondere kann die erste und/ oder zweite metallische Schicht hinsichtlich Gewichts- Atom- und/ oder Volumenanteilen überwiegend oder vollständig aus eutektischem Blei-Zinn, Cadmium-Zinn oder - besonders bevorzugt - Indium-Zinn bestehen.

Zur Verbesserung der Benetzung und/ oder Diffusion im Falle der stoffschlüssigen Verbindung ist die Temperatur während des dritten Verfahrensschrittes in der ersten und/ oder zweiten Schicht wenigstens zeitweise größer als Raumtemperatur. Vorzugsweise ist die ist die Temperatur während des dritten Verfahrensschrittes in der ersten und/ oder zweiten Schicht wenigstens zeitweise größer als 30°C. Beispielsweise liegt sie zeitweise zwischen 50° und 100°C. In diesem Temperaturbereich kann auch die Verfestigung des Fügemittels begünstigt sein, in der Hinsicht, dass die Verfestigung zeitlich beschleunigt wird und/ oder die Festigkeit des verfestigten Fügemittels erhöht wird.

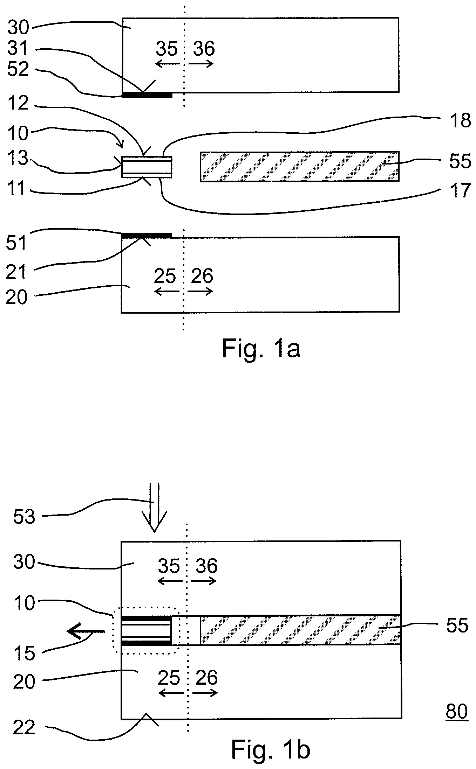

Nachfolgend wird die Erfindung anhand von fünf Ausführungsbeispielen näher erläutert. Dazu zeigen schematisch und nicht notwendigerweise maßstabstreu
- Fig. 1a: eine Seitenansicht auf eine erfindungsgemäße Anordnung der Komponenten im zweiten Verfahrensschritt eines ersten Ausführungsbeispiels zur erfindungsgemäßen Herstellung eines Diodenlaserbauelementes,
- Fig. 1b: eine Seitenansicht auf eine erfindungsgemäße Anordnung der Komponenten im dritten Verfahrensschritt des ersten Ausführungsbeispiels,

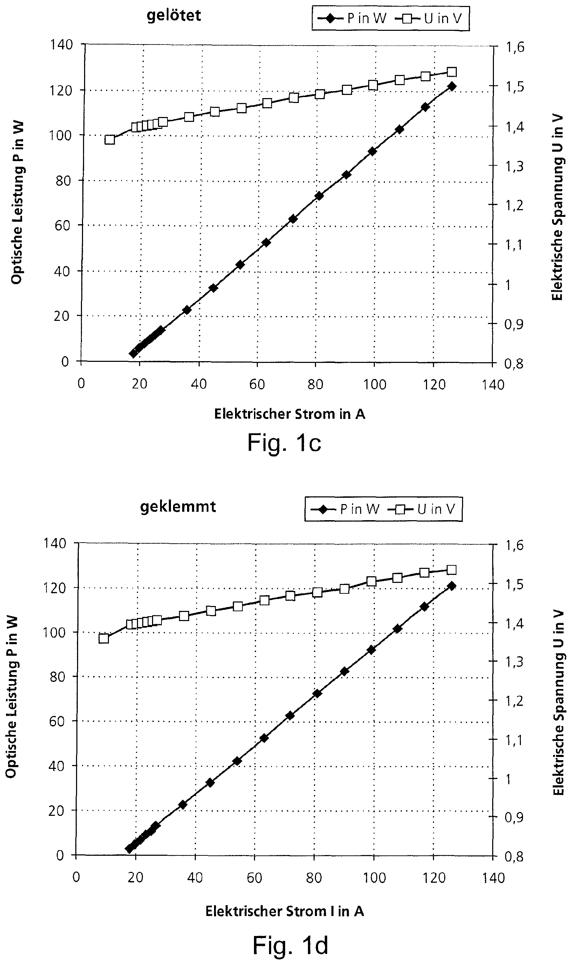

- Fig. 1c: eine Strom-Licht/-Spannungs-Kurve eines gelöteten, konventionellen Diodenlaserbauelementes,
- Fig. 1: d eine Strom-Licht/-Spannungs-Kurve des gemäß des ersten Ausführungsbeispiels herstellten Diodenlaserbauelementes,
- Fig. 1e: ein Nahfeldprofil der optischen Leistungsverteilung von Emittern eines gelöteten, konventionellen Diodenlaserbauelementes,
- Fig. 1f: ein Nahfeldprofil der optischen Leistungsverteilung von Emittern eines gemäß des ersten Ausführungsbeispiels herstellten Diodenlaserbauelementes,
- Fig. 2a: eine Seitenansicht auf eine erfindungsgemäße Anordnung der Komponenten für die Durchführung eines ersten Abschnittes des zweiten Verfahrensschrittes eines zweiten Ausführungsbeispiels zur erfindungsgemäßen Herstellung eines Diodenlaserbauelementes,
- Fig. 2b: eine Seitenansicht auf eine erfindungsgemäße Anordnung der Komponenten für die Durchführung eines, dem ersten Abschnitt zeitlich nachgelagerten, zweiten Abschnittes des zweiten Verfahrensschrittes des zweiten Ausführungsbeispiels,
- Fig. 2c: eine Seitenansicht auf eine erfindungsgemäße Anordnung der Komponenten im dritten Verfahrensschritt des zweiten Ausführungsbeispiels,
- Fig. 3a: eine Frontansicht auf eine erfindungsgemäße Anordnung der Komponenten im zweiten Verfahrensschritt eines dritten Ausführungsbeispiels zur erfindungsgemäßen Herstellung eines Diodenlaserbauelementes,
- Fig. 3b: eine Frontansicht auf eine erfindungsgemäße Anordnung der Komponenten in einem ersten Abschnitt des dritten Verfahrensschrittes des dritten Ausführungsbeispiels,
- Fig. 3c: eine Frontansicht auf eine erfindungsgemäße Anordnung der Komponenten in einem, dem ersten Abschnitt zeitlich nachgelagerten, zweiten Abschnitte des dritten Verfahrensschrittes des dritten Ausführungsbeispiels,
- Fig. 4a: eine Seitenansicht auf die Komponenten einer Diodenlaser-Unterbaugruppe zur Verwendung bei der Herstellung eines Diodenlaserbauelementes gemäß eines vierten Ausführungsbeispiels des erfindungsgemäßen Verfahrens,
- Fig. 4b: eine Seitenansicht auf die Diodenlaser-Unterbaugruppe von Fig. 4a,
- Fig. 4c: eine Seitenansicht auf eine erfindungsgemäße Anordnung der Komponenten im zweiten Verfahrensschrittes des vierten Ausführungsbeispiels zur erfindungsgemäßen Herstellung eines Diodenlaserbauelementes,
- Fig. 4d: eine Seitenansicht auf eine erfindungsgemäße Anordnung der Komponenten im dritten Verfahrensschritt des vierten Ausführungsbeispiels.
- Fig. 5a: eine Frontansicht auf die Komponenten einer Diodenlaser-Unterbaugruppe zur Verwendung bei der Herstellung eines Diodenlaserbauelementes gemäß eines fünften Ausführungsbeispiels des erfindungsgemäßen Verfahrens,
- Fig. 5b: eine Frontansicht auf die Diodenlaser-Unterbaugruppe von Fig. 5a,
- Fig. 5c: eine Seitenansicht auf eine erfindungsgemäße Anordnung der Komponenten im zweiten Verfahrensschrittes des fünften Ausführungsbeispiels zur erfindungsgemäßen Herstellung eines Diodenlaserbauelementes,
- Fig. 5d: eine Frontansicht auf eine erfindungsgemäße Anordnung der Komponenten im dritten Verfahrensschritt des fünften Ausführungsbeispiels.

Die verwendeten Schraffuren kennzeichnen dabei das Fügemittel und sind nicht als Querschnittsansicht zu interpretieren.

Als Metallisierungen 17 und 18 ausgebildete Kontaktschichten auf einander gegenüberliegenden Seiten eines Laserdiodenelementes 10 sind nur in den Fig. 1a und 1b des ersten Ausführungsbeispiels dargestellt und werden allen übrigen Figuren als gegeben vorausgesetzt, der Übersichtlichkeit halber jedoch weggelassen.

Gleich Bezugszeichen bezeichnen gleich oder gleichwertige Objekte. Bezüglich in der Beschreibung nicht erläuterter Bezugszeichen wird auf die Bezugszeichenliste verwiesen.

### ERSTES AUSFÜHRUNGSBEISPIEL

Für die Herstellung eines Diodenlaserbauelementes gemäß einem ersten Ausführungsbeispiel des erfindungsgemäßen Verfahrens werden im ersten Verfahrensschritt ein erster Wärmeleitkörper 20 aus Kupfer und ein zweiter Wärmeleitkörper 30 aus Kupfer bereitgestellt. Beide Wärmeleitkörper 20 und 30 sind äußerlich mit einer Nickel- und einer Goldschicht überzogen. Der erste Wärmeleitkörper 20 weist einen ersten Verbindungsabschnitt 26 und einen ersten Kontaktabschnitt 25 mit einer ersten Anschlussfläche 21 auf. Der zweite Wärmeleitkörper 30 weist einen zweiten Verbindungsabschnitt 36 und einen zweiten Kontaktabschnitt 35 mit einer zweiten Anschlussfläche 31 auf. Auf die erste Anschlussfläche 21 ist eine erste Indiumschicht 51 aufgebracht und auf die zweite Anschlussfläche 31 ist eine zweite Indiumschicht 52 aufgebracht.

Der erste Wärmeleitkörper 20 wird gegenüber dem zweiten Wärmeleitkörper 30 im zweiten Verfahrensschritt derart orientiert, dass die erste Anschlussfläche 21 und die zweite Anschlussfläche 31 einander gegenüberliegen (Fig. 1a).

Ferner wird im ersten Verfahrensschritt als Halbleiterbauelement-Anordnung ein Laserdiodenbarren 10 bereitgestellt, der auf einer ersten Seite eine erste Metallisierung 17 mit einer vergoldeten äußeren elektrischen Kontaktfläche 11 aufweist und auf einer zweiten Seite eine zweite Metallisierung 18 mit einer vergoldeten äußeren Kontaktfläche 12 aufweist. Dabei ist der Laserdiodenbarren 10 im zweiten Verfahrensschritt so zwischen dem ersten Kontaktabschnitt 25 und dem zweiten Kontaktabschnitt 35 gebracht, dass seine erste elektrische Kontaktfläche 11 der ersten Anschlussfläche 21 gegenüberliegt und seine, der ersten elektrischen Kontaktfläche 11 gegenüberliegende, zweite elektrische Kontaktfläche 12 der zweiten Anschlussfläche 31 gegenüberliegt. Zwischen dem ersten Verbindungsabschnitt 26 und dem zweiten Verbindungsabschnitt 36 ist ein Fügemittel 55 eingebracht, das zum Zeitpunkt des Einbringens nicht notwendiger Weise als Schicht vorliegen muss, sondern auch als Tropfen oder Tropfenfeld auf die Oberfläche des ersten Verbindungsabschnittes 26 und/ oder des zweiten Verbindungsabschnittes 36 appliziert werden kann, die dem jeweils anderen Verbindungsabschnitt gegenüberliegt. In diesem Fall wird ein mit Keramikpartikeln gefüllter Epoxidharz-Klebstoff (kurz: Epoxy) als elektrisch isolierendes Fügemittel 55 verwendet. Auf der dem Fügemittel abgewandten Seite weist der Laserdiodenbarren 10 eine Strahlungsemissionsfläche 13 auf, die senkrecht zu den beiden elektrischen Kontaktflächen 11 und 12 liegt.

Im dritten Verfahrensschritt wird eine Druckkraft 53 auf die dem Laserdiodenbarren abgewandte Seite des zweiten Kontaktabschnittes 35 aufgebracht. Der erste Wärmeleitkörper 20 liegt mit seiner dem Laserdiodenbarren abgewandten Seite 22 auf einem unbeweglichen oder unbewegten Gegenstück auf, welches in Fig. 1b nicht dargestellt ist und als Anschlag dient. Mit diesem Anschlag baut sich eine der Druckkraft 53 entgegengesetzte Gegenkraft auf, die gemeinsam mit der Druckkraft 53 für eine Druckbelastung der Indiumschichten 51 und 52 sorgt. Die Temperatur der Anordnung wird von Raumtemperatur auf 70°C erhöht, um die Aushärtung und die damit einhergehende Verfestigung der Fügemittelschicht 55 herbeizuführen, zu unterstützen oder zu beschleunigen und die Neigung des Indiums der metallischen Schichten 51 und 52 zur Diffusion in das Gold der Metallisierungen 17 und 18 zu erhöhen. Die Temperatur in den Indiumschichten überschreitet nicht 70°C während des dritten Verfahrensschrittes bis zur Fertigstellung des Diodenlaserbauelementes 80 als Halbleitermodul. Dennoch wird durch die Diffusion des festen Indiums in das feste Gold eine stoffschlüssige Verbindung des Laserdiodenbarrens 10 mit beiden Wärmeleitkörpern 20 und 30 erreicht. Die Herstellung des Diodenlaserbauelementes 80 ist mit der Verfestigung des Fügemittels 55, die eine stabile stoffschlüssige Verbindung zwischen den beiden Wärmeleitkörpern 20 und 30 abseits des Laserdiodenelementes 10 bildet, und der Abkühlung der Anordnung zurück auf Raumtemperatur abgeschlossen. Dabei hält der vom Fügemittel 55 gebildete Stoffschluss die Druckbelastung der Wärmeleitkörper 20 und 30 auf die Indiumschichten 51 und 52 zumindest teilweise aufrecht, so dass die Indiumschichten 51 und 52 vor einer Zug-, Scher- und Schälbelastung geschützt sind und eine ausreichende elektrische und thermische Kontaktierung des Laserdiodenelementes 10 auch während des Betriebes des Diodenlaserbauelementes 80 gewährleistet werden kann. Zur Kühlung des Diodenlaserbauelementes im Betrieb wird ein Kühlkörper (nicht dargestellt) an die Anbindungsfläche 22 auf der dem Laserdiodenbarren 10 abgewandten Seite des ersten Wärmeleitkörpers angeschlossen. Die Emissionsrichtung der im Betrieb emittierten Diodenlaserstrahlung ist durch den Pfeil 15 in Fig. 1b angedeutet. Bedingt durch die Tatsache, dass die Indiumschichten 51 und 52 auch Lotschichten sein können, im vorliegenden Fall jedoch nicht als solche verwendet werden, weil nämlich während der Herstellung des Diodenlasermoduls zu keinem Zeitpunkt die Schmelztemperatur von Indium - nämlich 157 °C - in keiner der beiden Indiumschichten 51 und 52 überschritten wird, lässt sich dieses Herstellungsverfahren als Klemmung des Laserdiodenbarrens 10 bezeichnet.

Dem gegenüber wird ein Herstellungsverfahren, bei dem die Schmelztemperatur einer oder beider Indiumschichten 51 und 52 überschritten wird, als Lötung des Laserdiodenbarrens 10 bezeichnet. In der Regel sollte eine Lötung bessere thermische Eigenschaften - ausgedrückt im thermischen Widerstand - des Diodenlaserbauelementes aufweisen als eine Klemmung. Nachteilig an der Lötung ist der bei Schmelztemperatur (besser: Verfestigungstemperatur) des Lotes erzeugte Stoffschluss, der insbesondere bei beidseitiger Lötung beider Indiumschichten 51 und 52 hohe mechanische Spannungen, insbesondere mit inhomogenem Verlauf über die Breite des Laserdiodenbarrens 10 von Emitter zu Emitter in den Laserdiodenbarren 10 einbringt. Da die optischen Eigenschaften der Strahlung der Emitter stark abhängig vom Spannungszustand im jeweiligen Emitter sind, ist mit entsprechenden inhomogenen Abstrahlungseigenschaften verschiedener Bereiche des Laserdiodenbarrens 10 zu rechnen.

Für einen Vergleich von beidseitig mit Indiumlot gelöteten Laserdiodenbarren 10 und beidseitig mit Indiumschichten 51 und 52 geklemmten Laserdiodenbarren 10 einer Emissionswellenlänge in der Nähe von 940 nm wurden mehrere Diodenlaserbauelemente 80 beider Varianten hergestellt und miteinander verglichen. Die Fig. 1c bis 1f geben die Eigenschaften des jeweiligen Vertreters mit der höchsten elektro-optischen Effizienz bei einer optischen Nennleistung von 120 W jeder Variante wieder. Fig. 1c zeigt die Strom-Licht/- Spannungs-Kurve des betreffenden beidseitig gelöteten Diodenlaserbauelementes 80 und Fig. 1d zeigt die Strom-Licht/-Spannungs-Kurve des betreffenden beidseitig geklemmten erfindungsgemäß hergestellten Diodenlaserbauelementes 80. Die elektro-optischen, mechanischen und thermischen Eigenschaften beider Varianten sind in Tab. 1 einander gegenübergestellt:

**Tab. 1: Vergleich beidseitig gelöteter und beidseitig geklemmter Laserdiodenbarren.**

| | Schwellstrom | Steilheit | Effizienz | Thermischer Widerstand | Smile |
|---|---|---|---|---|---|
| gelötet | 14,4 A | 1,1 W/A | 63 % | 0,38 K/W | 1,5 µm |
| geklemmt | 15,3 A | 1,1 W/A | 63 % | 0,37 K/W | 0,6 µm |

Dabei zeigt sich, dass die geklemmte Variante eine mit der gelöteten Variante vergleichbare elektro-optische Effizienz aufweist. Auch die thermischen Eigenschaften sind einander sehr ähnlich. Hinsichtlich des thermischen Widerstand ist darauf hinzuweisen, dass seine Ermittlung von thermomechanischen Mechanismen beeinflusst ist, so dass von einem systematischen Fehler von +/- 0,03 K/W auszugehen ist. Der smile bezeichnet die Verkrümmung des Laserdiodenbarrens 10 entlang seiner Breitenachse ausgedrückt als Summe der beiden maximalen positiven und negativen Abweichungen von einer aus den Messwerten interpolierten Geraden. Hier ist der geklemmten Variante eindeutig der Vorzug gegenüber der gelöteten zu geben, was sich besonders positiv hinsichtlich der Effizienz bei der Einkopplung der Strahlung mehrerer Emitter in eine Lichtleitfaser auswirkt.

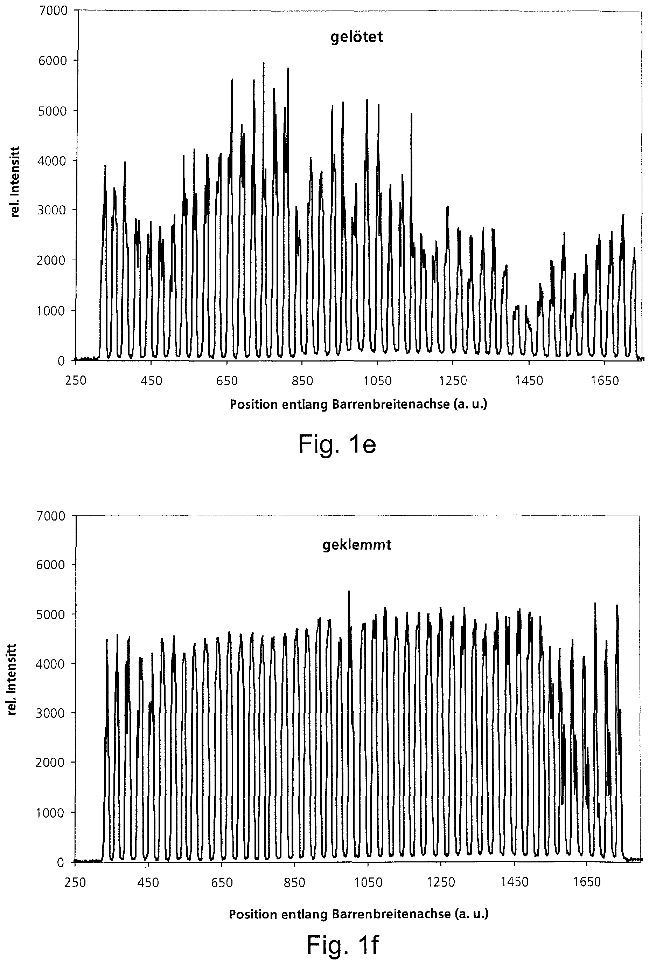

Fig. 1e zeigt das Nahfeldprofil der optischen Leistungsverteilung von Emittern des gelöteten Diodenlaserbauelementes 80 und Fig. 1f zeigt das Nahfeldprofil der optischen Leistungsverteilung von Emittern des beidseitig geklemmten Diodenlaserbauelementes 80. Wie bereits weiter oben in der Erfindungsbeschreibung hervorgehoben, zeigt sich bei den optischen Leistungen der Emitter des geklemmten Laserdiodenbarrens 10 eine deutlich bessere Leistungshomogenität als bei den Emittern des gelöteten Laserdiodenbarrens 10.

### ZWEITES AUSFÜHRUNGSBEISPIEL

Im Gegensatz zum ersten Ausführungsbeispiel wird zur Herstellung des Diodenlaserbauelementes des zweiten Ausführungsbeispiels keine doppelseitige Klemmung, sondern nur eine einseitige (substratseitige) Klemmung des Laserdiodenbarrens 10 vorgenommen, nachdem die Epitaxieseite 11 des Laserdiodenbarrens 10 an den ersten Wärmeleitkörper 20 angelötet wurde.

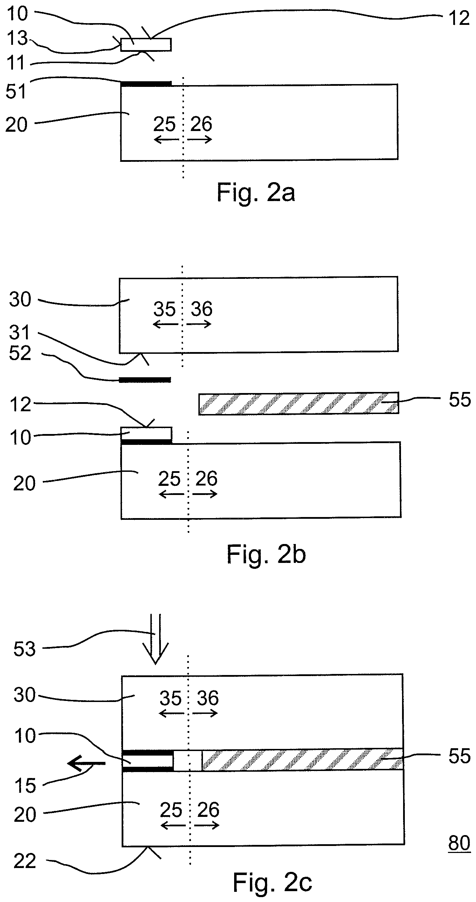

Der erste Wärmeleitkörper 20 besteht aus einem Silber-Diamant-Komposit-Werkstoff-Kern der äußerlich zumindest auf der dem Laserdiodenbarren 10 und auf der dem Laserdiodenbarren 10 abgewandten Seite eine Kupferschicht aufweist, die sich in einfacher Weise mechanisch bearbeiten lässt, um ebene Anbindungsflächen herzustellen. Silber und Diamant des ersten Wärmeleitkörpers stehen dabei in einem Mischungsverhältnis, das dem ersten Wärmeleitkörper 20 einen thermischen Ausdehnungskoeffizienten verleiht, der nur 0,5 bis 1,5 ppm/ K größer ist als der thermische Ausdehnungskoeffizient des Laserdiodenbarrens 10. Damit wird eine spannungsarme epitaxieseitige Hartlötung des Laserdiodenbarrens 10 auf dem Wärmeleitkörper 20 möglich. Dazu wird im ersten Verfahrensschritt eine Gold-Zinn-Lotschicht 51 auf die dem Laserdiodenbarren 10 zugewandte Seite des Kontaktabschnittes 25 ersten Wärmeleitkörpers 20 aufgebracht, die eutektisches Gold-Zinn im Gewichtsverhältnis Gold zu Zinn von 80:20 aufweist (Fig. 2a). In einem ersten Abschnitt des zweiten Verfahrensschritts wird der Laserdiodenbarren 10 damit über seine epitaxieseitige Kontaktfläche 11 an den ersten Wärmeleitkörper 20 angelötet. In einem sich daran anschließenden zweiten Abschnitt des zweiten Verfahrensschrittes wird eine Indiumfolie 52 von 5 µm bis 100 µm Dicke zwischen die den Laserdiodenbarren 10 und den zweiten Kontaktabschnitt 35 eines zweiten Wärmeleitkörpers 30 aus Kupfer gebracht sowie ein elektrisch isolierende Fügemittel 55 zwischen die einander gegenüberliegenden Verbindungsabschnitte 26 und 36 des ersten und zweiten Wärmeleitkörpers 20 und 30 (Fig 2b). Im dritten Verfahrensschritt wird eine Druckkraft 53 und Wärme beaufschlagt, wobei die Temperatur in der Indiumschicht 52 100 °C nicht überschreitet. Dabei diffundiert das Indium teilweise in die substratseitige Goldschicht der zweiten Kontaktfläche 12 des Laserdiodenbarrens und teilweise in das Kupfer des zweiten Wärmeleitkörpers 30, dessen Oberfläche zumindest im Diffusionsbereich zuvor ausreichend von Sauerstoff befreit wurde.

Mit der Aushärtung des Fügemittels 55 ist der Herstellungsprozess des Diodenlaserbauelementes 80 abgeschlossen.

### DRITTES AUSFÜHRUNGSBEISPIEL

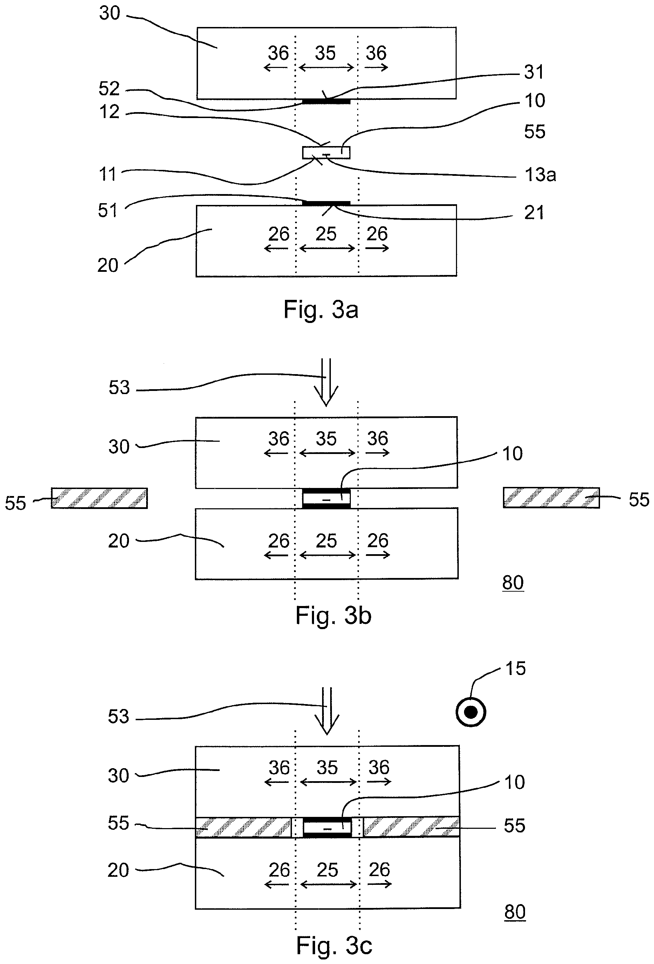

Im dritten Ausführungsbeispiel wird als Laserdiodenelement eine Laserdiode 10 mit einem Emitter 13a verwendet. Da die Resonatorlänge in Tiefenrichtung der Fig. 3a größer ist als die Breite der Laserdiode 10, ist eine Wärmespreizung zu beiden Seiten links und rechts parallel zu den Kontaktflächen 11 und 12 der Laserdiode 10 und senkrecht zur Resonatorrichtung beziehungsweise Lichtemissionsrichtung 15 vorteilhaft. In diesem Sinne weisen der erste und der zweite Wärmeleitkörper 20 und 30 jeweils zwei einander gegenüberliegende Verbindungsabschnitte 26 und 36 - einen linken und einen rechten - auf, zwischen denen jeweils der Kontaktabschnitt 25 beziehungsweise 35 liegt.

Im Vakuum werden die Anschlussflächen 21 und 31 der Kontaktabschnitte 25 und 35 von der nativen Aluminiumoxidschicht der aus Aluminium bestehenden Wärmeleitkörper 20 und 30 mit einem geeigneten Verfahren befreit. Ohne anschließend einer oxidierenden Umgebungsatmosphäre ausgesetzt zu, sein werden die Anschlussflächen 21 und 31 der Kontaktabschnitte 25 und 36 im Vakuum mit jeweils einer Indiumschicht 51 beziehungsweise 52 bedampft (Fig. 3a). Durch die Indiumschicht 51/ 52 ist die jeweilige Anschlussfläche 21/ 31 vor Oxidation geschützt, so dass auch in einer oxidierenden Umgebungsatmosphäre ein widerstandsarmer elektrischer Übergang zwischen der Indiumschicht 51/ 52 und dem jeweiligen Wärmeleitkörper 20/ 30 etabliert und aufrecht erhalten werden kann.

In einem ersten Abschnitt des dritten erfindungsgemäßen Verfahrensschrittes wird zunächst die Anordnung von erstem Wärmeleitkörper 20, Laserdiode 10 und zweitem Wärmeleitkörper 30 mit Druck 53 beaufschlagt, um eine kraftschlüssige Verbindung der Komponenten zu erzielen, ohne dass zwischen den Verbindungsabschnitten 26 und 36 der Wärmeleitkörper 20 und 30 ein Fügemittel 55 vorliegt (Fig. 3b). Dieses Fügemittel 55 wird erst im Verlauf des dritten erfindungsgemäßen Verfahrensschrittes unter Aufrechterhaltung des Druckes 53 zwischen die Verbindungsabschnitte 26 und 36 eingebracht. Damit liegt es erst in einem zweiten Abschnitt des dritten erfindungsgemäßen Verfahrensschrittes zwischen den Verbindungsabschnitten 26 und 36 vor, während dem es sich unter Aufrechterhaltung des Druckes 53 verfestigt und zu einem Stoffschluss zwischen den Wärmeleitkörpern 20 und 30 beiträgt. Dabei muss das Fügemittel nicht notwendigerweise elektrisch isolierend sein, weil bereits die oberflächlichen nativen Aluminiumoxidschichten der Wärmeleitkörper 20 und 30 für eine elektrische Isolierung und damit der nötigen Potentialtrennung der Wärmeleitkörper 20 und 30 voneinander sorgen.

In einer ersten alternativen Herstellungsvariante werden die Anschlussflächen 21/ 31, nach dem sie im Vakuum von der nativen Aluminiumoxidschicht befreit wurden, im Vakuum mit einer Titan-Platin-Gold-Metallisierung versehen, die als Schutz vor Oxidation dient. Die Indiumschicht wird anstelle durch Aufdampfen durch Einfügen jeweils einer Indiumfolie 51/ 52 zwischen die Anschlussflächen 21/ 31 und die elektrischen Kontaktflächen 11/ 12 in die Anordnung eingebracht.

In einer zweiten alternativen Herstellungsvariante werden nach der Reinigung der Anschlussflächen 21/ 31 der Aluminiumoberfläche im Vakuum in demselben Vakuum sowohl Laserdiode 10 zwischen die Kontaktabschnitte 25/ 35 als auch Indiumfolien 51/ 52 beidseitig der Laserdiode 10 zwischen die jeweiligen Kontaktabschnitte 25/35 und die Laserdiode gebracht. Das Aufbringen der Kraft 53 erfolgt ebenfalls im Vakuum. Während der Belüftung des Prozessraumes bleibt die Kraft 53 erhalten bis schließlich das Fügemittel zwischen die Verbindungsabschnitte 26 und 36 eingebracht wird und ausgehärtet ist.

### VIERTES AUSFÜHRUNGSBEISPIEL

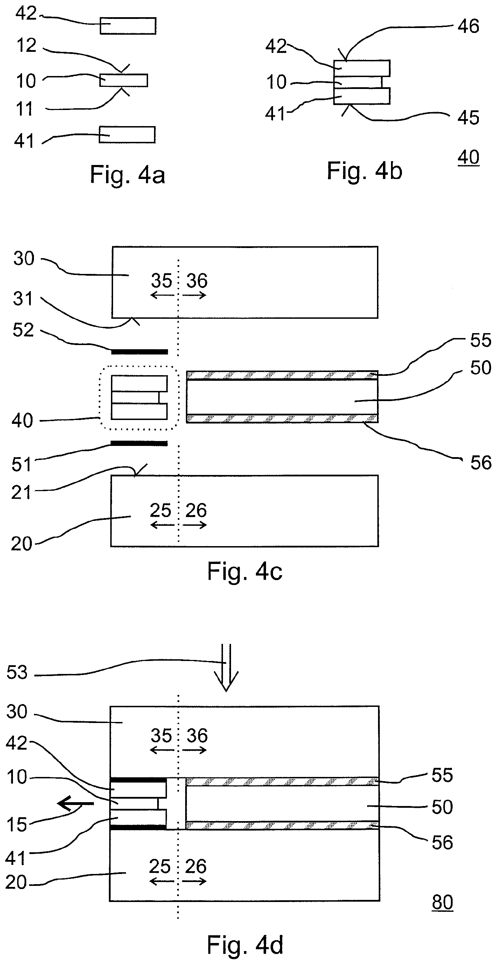

Im vierten Ausführungsbeispiel wird die Halbleiterbauelement-Anordnung nicht wie in den drei vorhergehenden Ausführungsbeispielen durch ein Laserdiodenelement bereitgestellt, sondern durch eine Diodenlaser-Unterbaugruppe 40 mit einem Laserdiodenbarren 10, an dessen epitaxieseitiger Kontaktfläche 11 ein erster elektrisch leitfähiger Kontaktkörper 41 stoffschlüssig befestigt ist und an dessen substratseitiger Kontaktfläche 12 ein zweiter elektrisch leitfähiger Kontaktkörper 42 stoffschlüssig befestigt ist. (Fig. 4a, Fig. 4b). Beide elektrisch leitfähige Kontaktkörper 41 und 42 sind durch Gold-metallisierte, 300µm dicke Kupfer-Wolfram-Substrate (CuW-Substrate) bereitgestellt, die einen Kupfer-Wolfram-Verbundwerkstoff aufweisen, in dem Verhältnis der Anteile Kupfer und Anteile Wolfram derart vorliegt, dass sich für die Kupfer-Wolfram-Substrate ein thermischer Ausdehnungskoeffizient ergibt, der von dem des Laserdiodenbarrens 10 um nicht mehr als 2 ppm/ K abweicht. Für einen GaAs-Laserdiodenbarren 10 ist das Verhältnis der Gewichtsanteile Kupfer zu Wolfram vorzugsweise 10 zu 90.

Die CuW-Substrate 41 und 42 sind mittels Gold-Zinn-Lot, welches Gold und Zinn im Gewichtsverhältnis von 80 zu 20 enthält, an den Laserdiodenbarren 10 angelötet. Das Gold-Zinn-Lot ist im Gegensatz zu Indium stabil unter vergleichsweise hohen thermomechanischen und elektromechanischen Wechsellasten, so dass die unmittelbare elektrische Kontaktierung des Laserdiodenbarrens durch die Verwendung der Kontaktkörper 41 und 42 vor Degradation auch bei hohen Leistungsanforderungen geschützt ist.

Die Diodenlaser-Unterbaugruppe 40 weist an ihrem ersten Kontaktkörper 41 eine erste, vom Laserdiodenbarren 10 abgewandte, thermische Kontaktfläche 45 auf und an ihrem zweiten Kontaktkörper 42 eine zweite, vom Laserdiodenbarren 10 abgewandte thermische Kontaktfläche 46, die der ersten thermischen Kontaktfläche 45 gegenüberliegt.

Die erste thermische Kontaktfläche 45 steht bereit zur elektrischen und thermischen Kontaktierung durch einen ersten Wärmeleitkörper 20 aus Kupfer (Fig. 4c). Die zweite thermische Kontaktfläche 46 steht bereit zur elektrischen und thermischen Kontaktierung durch einen zweiten Wärmeleitkörper 30 aus Kupfer. Beide Wärmeleitkörper 20 und 30 weisen jeweils erfindungsgemäße Kontaktabschnitte 25 und 35 in Senkrechtprojektion des Diodenlaser-Unterbaugruppe 40 in Richtung der pn-Übergänge seines Laserdiodenbarrens 10 auf mit jeweils der Diodenlaser-Unterbaugruppe 40 zugewandten Anschlussflächen 21 beziehungsweise 31. Beide Wärmeleitkörper 20 und 30 weisen jeweils erfindungsgemäße Verbindungsabschnitte 26 und 36 die sich außerhalb der besagten Senkrechtprojektion einander gegenüberliegend erstrecken.

Zwischen die erste Anschlussfläche 21 und die erste thermische Kontaktfläche 45 wird eine erste Indiumfolie 51 von 50 µm Dicke gebracht. Zwischen die zweite Anschlussfläche 31 und die zweite thermische Kontaktfläche 46 wird eine zweite Indiumfolie 52 von 50 µm Dicke gebracht. Zwischen den ersten Verbindungsabschnitt 26 und den zweiten Verbindungsabschnitt wird eine beidseitig mit Epoxidharz-KlebstoffSchichten 55 und 56 versehene 750 µm dicke Aluminiumoxid-Keramikplatte eingebracht.

Im Verbindungsschritt des Herstellverfahrens wird äußerlich eine Kraft 53 auf die der Diodenlaser-Unterbaugruppe 40 abgewandte Seite des zweiten Wärmeleitkörpers 30 aufgebracht, während die der Diodenlaser-Unterbaugruppe 40 abgewandte Seite des ersten Wärmeleitkörpers 20 fest auf der Heizplatte eines Ofens aufliegt. Die Prozesstemperatur überschreitet 70°C. Sie überschreitet 100°C jedoch nicht. Durch Festkörperdiffusion des Indiums der Indiumfolien 51 und 52 sowohl in das oberflächennahe Kupfer der Wärmeleitkörper 20 und 30 als auch in die Gold-Metallisierung der CuW-Substrate wird eine stoffschlüssige Diodenlaserbauelement-Einheit erzielt, die zusätzlich durch den von den Klebstoffschichten 55 und 56 bedingten Stoffschluss zwischen den beiden Verbindungsabschnitten stabilisiert wird.

### FÜNFTES AUSFÜHRUNGSBEISPIEL

Gegenüber dem vierten Ausführungsbeispiel unterscheidet sich das fünfte Ausführungsbeispiel dadurch dass anstatt des Laserdiodenbarrens mit zahlreichen Emittern ein sogenannter Minibarren 10 von 120 µm Dicke mit einem 2x3-Feld von Emittern verwendet wird, welche in zwei Reihen zu je drei Emittern übereinander angeordnet sind, wobei der Abstand der beiden Reihen voneinander von 2 bis 5 µm beträgt. Eine solche Struktur übereinander angeordneter Emitter kann epitaktisch mittels MOCVD (metal organic chemical vapor deposition der MBE (molecular beam epitaxy) erzeugt werden.

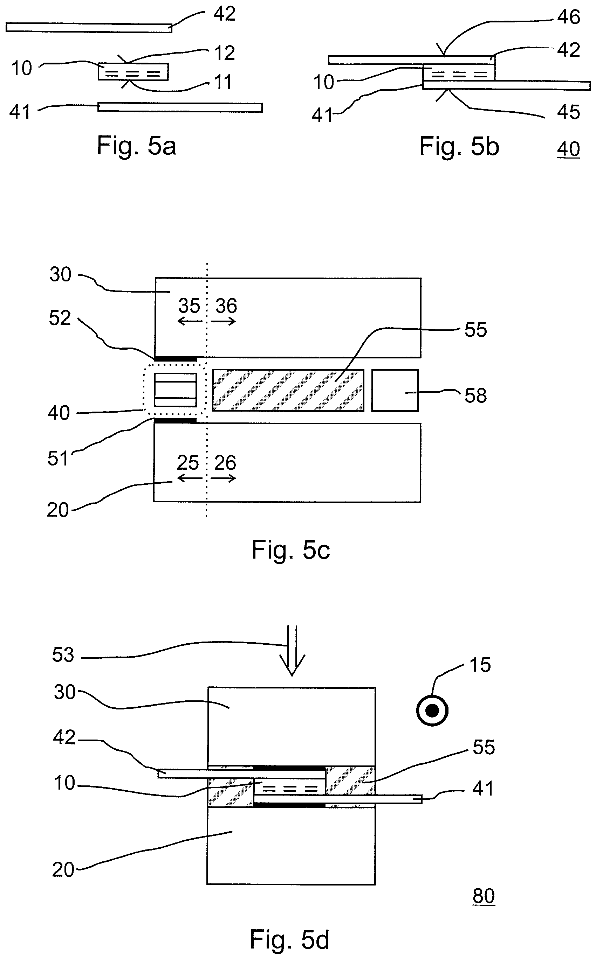

Als Kontaktkörper 41 und 42 dienen beidseitig kupferbeschichtete Molybdän-Bänder von jeweils 50 µm Gesamtdicke, die derart unter Verwendung eines Gold-Zinn-Lotes an einander gegenüberliegenden Kontaktflächen 11 und 12 des Minibarrens befestigt sind, dass ihre freien Endabschnitte zu einander gegenüberliegenden Seiten des Minibarrens parallel zu den Kontaktflächen und senkrecht zur Abstrahlrichtung 15 über den Minibarren 10 hervorstehen (Fig. 5b).

Die Wärmeleitkörper 20 und 30 sind Aluminiumquader, die eine oberflächliche, native oder künstlich verstärkte, Oxidschicht mit elektrisch isolierender Eigenschaft aufweisen. Auf diese Oxidschicht sind auf jeden Kontaktabschnitt 25 und 35 der Wärmeleitkörper 20 und 30 jeweils eine 10 µm dünne Indiumschicht 51 und 52 aufgebracht (Fig.5c). Zwischen die Verbindungsabschnitte 26 und 36 der Wärmeleitkörper 20 und 30 ist eine 250 µm dicke Schicht 55 elektrisch leitfähigen silbergefüllten Epoxydharz-Klebstoffes eingebracht. Durch die oberflächlichen Oxidschichten der Aluminium-Wärmeleitkörper 20 und 30 wird ein Kurzschluss zwischen den Kontaktflächen 11 und 12 des Minibarrens 10 vermieden. Auf der der Diodenlaser-Unterbaugruppe 40 abgewandten Seite befindet sich ein Distanzstück 58 von 230 µm Dicke, welches einer Verkippung der Wärmeleitkörper 20 und 30 zueinander im Verbindungsprozess vorbeugen soll. Die Beaufschlagung mit Kraft und Wärme erfolgt wie im vorhergehenden Ausführungsbeispiel mit dem ihm gegenüber abweichenden Ergebnis, dass die Aluminium-Wärmeleitkörper 20 und 30 die Diodenlaser-Unterbaugruppe 40 nur kraftschlüssig kontaktieren, weil das Indium der Indiumschichten 51 und 52 die (Aluminium-)oxidschichten der Wärmeleitkörper nicht benetzt. Stabilisiert wird dieser Kraftschluss durch den Stoffschluss zwischen den Verbindungsabschnitten 26 und 36 der Wärmeleitkörper 20 und 30, der durch den verfestigten Klebstoff 55 vermittelt wird.

Die freien Endabschnitte der Molybdän-Bänder 41 und 42 ragen zu einander gegenüberliegenden Seiten seitlich über die Wärmeleitkörper 20 und 30 hervor und stehen zur elektrischen Kontaktierung zur Verfügung, während die Wärmeleitkörper 20 und 30 allein der thermischen Kontaktierung bedürfen.

### Bezugszeichenliste

- 10: Laserdiodenelement
- 11: erste elektrische Kontaktfläche
- 12: zweite elektrische Kontaktfläche
- 13: Strahlungsemissionsfläche
- 13a: Strahlungsemissionsabschnitt, Emitter
- 15: Strahlungsemissionsrichtungssymbol
- 17: erste Kontaktschicht, z.B. erste Metallisierung
- 18: zweite Kontaktschicht, z. B. zweite Metallisierung
- 20: erster Wärmeleitkörper
- 21: erste Anschlussfläche/ Wärmeeintrittsfläche
- 22: Anbindungsfläche des ersten Wärmeleitkörpers 20
- 25: Kontaktabschnitt des ersten Wärmeleitkörpers 20
- 26: Verbindungsabschnitt des ersten Wärmeleitkörpers 20
- 30: zweiter Wärmeleitkörper
- 31: zweite Anschlussfläche/ Wärmeeintrittsfläche
- 32: Anbindungsfläche des zweiten Wärmeleitkörpers 30
- 35: Kontaktabschnitt des zweiten Wärmeleitkörpers 30
- 36: Verbindungsabschnitt des zweiten Wärmeleitkörpers 30
- 40: Diodenlaser-Unterbaugruppe
- 41: erster Kontaktkörper
- 42 z: weiter Kontaktkörper
- 45: erste thermische Kontaktfläche
- 46: zweite thermische Kontaktfläche
- 50: Zwischenstück
- 51: erste metallische Schicht
- 52: zweite metallische Schicht
- 53: Kraftrichtungssymbol
- 55: erste Fügemittelschicht
- 56: zweite Fügemittelschicht
- 58: Distanzstück
- 80: Diodenlaserbauelement

## Patentansprüche

1. Verfahren zum Herstellen eines Halbleitermoduls (80),
**gekennzeichnet durch** folgende Schritte:
a) Bereitstellen
i) einer Halbleiterbauelement-Anordnung (10 / 40), die
- auf einer ersten Seite wenigstens einen ersten elektrischen Anschluss mit einer ersten Kontaktfläche (11 / 45) aufweist und
- auf einer der ersten Seite gegenüberliegenden zweiten Seite wenigstens einen zweiten elektrischen Anschluss mit einer zweiten Kontaktfläche (12 /46) aufweist,
ii) eines ersten Wärmeleitkörpers (20) mit einem ersten Kontaktabschnitt (25) und einem ersten Verbindungsabschnitt (26),
iii) wenigstens eines zweiten Wärmeleitkörpers (30) mit einem zweiten Kontaktabschnitt (35) und einem zweiten Verbindungsabschnitt (36),
iv) einer ersten metallischen Schicht (51),
v) wenigstens einer zweiten metallischen Schicht (52), sowie
vi) wenigstens eines Fügemittels (55);
b) Anordnen der Halbleiterbauelement-Anordnung (10 / 40) zwischen dem ersten und dem zweiten Wärmeleitkörper (20, 30) in der Weise, dass der erste Kontaktabschnitt (25) des ersten Wärmeleitkörpers (20) der ersten Kontaktfläche (11 / 45) gegenüberliegt, der zweite Kontaktabschnitt (35) des zweiten Wärmeleitkörpers (30) der zweiten Kontaktfläche (12 / 46) gegenüberliegt, wobei die
erste metallische Schicht (51) zumindest abschnittsweise zwischen dem ersten Kontaktabschnitt (25) und der ersten Kontaktfläche (11 /45) angeordnet ist, die zweite metallische Schicht (52) zumindest abschnittsweise zwischen dem zweiten Kontaktabschnitt (35) und der zweiten Kontaktfläche (12 / 46) angeordnet ist; wobei der erste Verbindungsabschnitt (26) des ersten Wärmeleitkörpers dem zweiten Verbindungsabschnitt (36) des zweiten Wärmeleitkörpers abseits der Halbleiterbauelement-Anordnung (10 / 40) gegenüberliegt und das Fügemittels (55) zumindest abschnittweise zwischen dem ersten Verbindungsabschnitt (26) und dem zweiten Verbindungsabschnitt (36) angeordnet ist,
c) Erzeugen wenigstens einer Kraft (53), die zumindest komponentenweise effektiv von einem der beiden Wärmeleitkörper (20 / 30) in Richtung des anderen Wärmeleitkörpers (30 / 20) orientiert ist und
Einrichten einer stoffschlüssigen Verbindung der beiden Wärmeleitkörper (20, 30) durch eine Verfestigung des Fügemittels (55)
wobei
die Temperatur im Schritt c) in der zweiten metallischen Schicht (52) nicht die Schmelztemperatur desjenigen metallischen Materials der zweiten metallischen Schicht (52), das die niedrigste Schmelztemperatur aufweist, überschreitet,
wobei
im Schritt c) das Erzeugen der wenigstens
einen Kraft (53) gleichzeitig mit dem Einrichten der stoffschlüssigen Verbindung durchgeführt wird und im Verfahrensschritt c) die Ausbildung einer kraftschlüssigen Verbindung zwischen dem zweiten Kontaktabschnitt (35) und der zweiten Kontaktfläche (12 / 46) erfolgt, die durch das verfestigte Fügemittel (55) aufrechterhalten wird.

2. Verfahren nach Anspruch 1,
**dadurch gekennzeichnet, dass**
die in dem Verfahrensschritt c) erzeugte Kraft (53) eine äußere Kraft ist, die von außen auf wenigstens einen der Wärmeleitkörper (20 / 30) aufgebracht wird und zumindest komponentenweise in Richtung des anderen Wärmeleitkörpers (30 / 20) orientiert ist,
wobei dem Verfahrensschritt c) ein Verfahrensschritt d) folgt, in dem die äußere Kraft (53) teilweise oder vollständig aufgehoben wird.

3. Verfahren nach einem der vorhergehenden Ansprüche,
**dadurch gekennzeichnet, dass**
im Verfahrensschritt b) eine stoffschlüssige Verbindung zwischen dem ersten Kontaktabschnitt (25) und der Halbleiterbauelement-Anordnung (10 / 40) unter Beteiligung wenigstens eines metallischen Materials der zwischen dem ersten Kontaktabschnitt (25) und der Halbleiterbauelement-Anordnung (10 / 40) angeordneten ersten metallischen Schicht (51) erfolgt.

4. Verfahren nach einem der vorhergehenden Ansprüche,
**dadurch gekennzeichnet, dass**
im Verfahrensschritt c) zusätzlich die Ausbildung einer kraftschlüssigen Verbindung zwischen dem ersten Kontaktabschnitt (25) und der ersten Kontaktfläche (11 / 45) erfolgt, die durch das verfestigte Fügemittel (55) aufrechterhalten wird.

5. Verfahren nach einem der Ansprüche 1 bis 3,
**dadurch gekennzeichnet, dass**
im Verfahrensschritt c) die Ausbildung einer stoffschlüssigen Verbindung zwischen dem zweiten Kontaktabschnitt (35) und der Halbleiterbauelement-Anordnung (10 / 40) durch Festkörper-Diffusion wenigstens eines metallischen Materials der zweiten metallischen Schicht (52) in einen metallischen Oberflächenbereich des zweiten Kontaktabschnittes (35) und/ oder des zweiten elektrischen Anschlusses und/ oder durch Festkörper-Diffusion von wenigstens einem metallischen Material des Oberflächenbereiches des zweiten Kontaktabschnittes (35) und/ oder des zweiten elektrischen Anschlusses in die zweite metallische Schicht (52) erfolgt, ohne dass eines der metallischen Materialien der zweiten metallischen Schicht (52), des Oberflächenbereiches des zweiten Kontaktabschnittes (35) oder des zweiten elektrischen Anschlusses, eine seiner gebildeten Verbindungen oder eine ihrer gebildeten Mischungen untereinander oder mit einer oder mehrerer seiner gebildeten Verbindungen in einen flüssigen Zustand übergeht.

6. Verfahren nach einem der Ansprüche 1 bis 5,
**dadurch gekennzeichnet, dass**
im Verfahrensschritt c) die Temperatur in der ersten metallischen Schicht (51) und der zweiten metallischen Schicht (52) nicht die Schmelztemperaturen derjenigen Materialien in den jeweiligen Schichten (51, 52) mit den jeweils niedrigsten Schmelztemperaturen überschreitet.

7. Verfahren nach Anspruch 6, **dadurch gekennzeichnet, dass** im Verfahrensschritt c) die Ausbildung einer stoffschlüssigen Verbindung zwischen dem zweiten Kontaktabschnitt (35) und der Halbleiterbauelement-Anordnung (10 / 40) durch Festkörper-Diffusion wenigstens eines metallischen Materials der zweiten metallischen Schicht (52) in einen metallischen Oberflächenbereich des zweiten Kontaktabschnittes (35) und/ oder des zweiten elektrischen Anschlusses und/ oder durch Festkörper-Diffusion von wenigstens einem metallischen Material des Oberflächenbereiches des zweiten Kontaktabschnittes (35) und/ oder des zweiten elektrischen Anschlusses in die zweite metallische Schicht (52) erfolgt, ohne dass eines der metallischen Materialien der zweiten metallischen Schicht (52), des Oberflächenbereiches des zweiten Kontaktabschnittes (35) oder des zweiten elektrischen Anschlusses, eine seiner gebildeten Verbindungen oder eine ihrer gebildeten Mischungen untereinander oder mit einer oder mehrerer seiner gebildeten Verbindungen in einen flüssigen Zustand übergeht und
die Ausbildung einer stoffschlüssigen Verbindung zwischen dem ersten Kontaktabschnitt (25) und der Halbleiterbauelement-Anordnung (10 / 40) durch Festkörper-Diffusion wenigstens eines metallischen Materials der ersten metallischen Schicht (51) in einen metallischen Oberflächenbereich des ersten Kontaktabschnittes (25) und/ oder des ersten elektrischen Anschlusses und/ oder durch Festkörper-Diffusion von wenigstens einem metallischen Material des Oberflächenbereiches des ersten Kontaktabschnittes (25) und/ oder des ersten elektrischen Anschlusses in die erste metallische Schicht (51) erfolgt, ohne dass eines der metallischen Materialien der ersten metallischen Schicht (52), des Oberflächenbereiches des ersten Kontaktabschnittes (25) oder des ersten elektrischen Anschlusses, eine seiner gebildeten Verbindungen oder eine ihrer gebildeten Mischungen untereinander oder mit einer oder mehrerer seiner gebildeten Verbindungen in einen flüssigen Zustand übergeht.

8. Verfahren nach einem der vorhergehenden Ansprüche,
**dadurch gekennzeichnet, dass**
wenigstens der Verfahrensschritt c) im Vakuum oder in einer bezüglich des ersten und/ oder zweiten metallischen Materials der ersten und/ oder zweiten metallischen Schicht (51, 52) chemisch inerten oder reduzierenden Atmosphäre erfolgt,
und / oder
**dadurch gekennzeichnet, daß**
der erste und der zweite Wärmeleitkörper (20, 30) aus wenigstens einem metallhaltigen Werkstoff bestehen und das Fügemittel (55) ein elektrisch isolierendes Fügemittel aus der Gruppe der Duroplaste und Zemente ist.

9. Verfahren nach einem der vorhergehenden Ansprüche,
**dadurch gekennzeichnet, dass**
im Verfahrensschritt a) oder b) die erste metallische Schicht (51) auf die erste Kontaktfläche (11 / 45) oder eine der Halbleiterbauelement-Anordnung (10 / 40) zugewandten erste Wärmeeintrittsfläche (21) des ersten Kontaktabschnitts (25) aufgebracht wird und/ oder die zweite metallische Schicht (52) auf die zweite Kontaktfläche (12 / 46) oder eine der Halbleiterbauelement-Anordnung (10 / 40) zugewandten zweite Wärmeeintrittsfläche (31) des zweiten Kontaktabschnitts (35) aufgebracht wird.

10. Verfahren nach einem der vorhergehenden Ansprüche,
**dadurch gekennzeichnet, dass**
wenigstens ein Material der ersten und/ oder zweiten metallischen Schicht (51, 52) ein chemisches Element aus der Gruppe Indium, Zinn, Blei und Cadmium enthält,
wobei bevorzugt
die erste und/ oder zweite metallische Schicht (51, 52) hinsichtlich Gewichts-, Atom- und/ oder Volumenanteilen überwiegend aus Indium bestehen und während des Verfahrensschrittes c) die Temperatur der ersten und/ oder zweiten metallischen Schicht (51, 52) zumindest zeitweise größer als 30°C ist.

11. Verfahren nach einem der vorhergehenden Ansprüche,
**dadurch gekennzeichnet, dass**
die Halbleiterbauelement-Anordnung (10) als Halbleiterbauelement (10) ausgebildet ist und die elektrischen Anschlüsse durch wenigstens eine erste elektrisch leitfähige Kontaktschicht (17) auf der ersten Seite des Halbleiterbauelementes (10) und wenigstens eine zweite elektrisch leitfähige Kontaktschicht (18) auf der zweiten Seite des Halbleiterbauelementes (10) gebildet sind, wobei die erste Kontaktfläche(11) auf der von dem Halbleiterbauelement (10) abgewandten Seite der ersten elektrisch leitfähigenKontaktschicht (17) angeordnet ist und die zweite Kontaktfläche (12) auf der von Halbleiterbauelement (10) abgewandten Seite der zweiten elektrisch leitfähigen Kontaktschicht (18) angeordnet ist.

12. Verfahren nach einem der Ansprüche 1 bis 11,
**dadurch gekennzeichnet, dass**
die Halbleiterbauelement-Anordnung (40) wenigstens ein Halbleiterbauelement (10) aufweist,
der erste elektrische Anschluss (41) als wenigstens ein erster elektrisch leitfähiger Kontaktkörper (41) ausgebildet ist, der mittels eines ersten elektrisch leitfähigen Fügemittels stoffschlüssig an einer ersten Seite des Halbleiterbauelementes (10) befestigt ist und
der zweite elektrische Anschluss (42) als ein zweiter elektrisch leitfähiger Kontaktkörper (42) ausgebildet ist, der mittels eines zweiten elektrisch leitfähigen Fügemittels stoffschlüssig an einer der ersten Seite des Halbleiterbauelementes (10) gegenüberliegenden zweiten Seite des Halbleiterbauelementes (10) befestigt ist,
wobei bevorzugt
das erste und/ oder das zweite elektrisch leitfähige Fügemittel Gold und Zinn enthält beziehungsweise enthalten und der erste und/ oder zweite elektrisch leitfähige Kontaktkörper (41, 42) Wolfram, Molybdän, Kohlenstoff, Bornitrid und/ oder Siliziumkarbid enthält beziehungsweise enthalten.

13. Verfahren nach Anspruch 11 oder 12,
**dadurch gekennzeichnet, dass**
der erste und der zweite Wärmeleitkörper (20, 30) hinsichtlich Gewichts-, Atom- und/ oder Volumenanteilen überwiegend aus Kupfer und/ oder Aluminium bestehen.

14. Verfahren nach einem der vorhergehenden Ansprüche,
**dadurch gekennzeichnet, dass**
der erste Wärmeleitkörper (20) und/ oder der zweite Wärmeleitkörper (30) ein Kühlkörper ist beziehungsweise sind,
und / oder
**dadurch gekennzeichnet, dass**
der erste Wärmeleitkörper (20) und/ oder der zweite Wärmeleitkörper (30) an wenigstens einen Kühlkörper angeschlossen wird beziehungsweise werden.

## Claims

1. Method for producing a semiconductor module (80), **characterized by** the following steps:
a) providing
i) a semiconductor component arrangement (10 / 40) which
- has on a first face at least one first electrical terminal which comprises a first contact surface (11 / 45) and
- has on a second face, which is opposite the first face, at least one second electrical terminal which comprises a second contact surface (12 / 46),
ii) a first heat conducting body (20) which comprises a first contact portion (25) and a first connecting portion (26),
iii) at least one second heat conducting body (30) which comprises a second contact portion (35) and a second connecting portion (36),
iv) a first metal layer (51),
v) at least one second metal layer (52), and
vi) at least one joining agent (55);
b) arranging the semiconductor component arrangement (10 / 40) between the first and the second heat conducting body (20, 30) in such a way that the first contact portion (25) of the first heat conducting body (20) faces the first contact surface (11 / 45), and the second contact portion (35) of the second heat conducting body (30) faces the second contact surface (12 / 46), the first metal layer (51) being arranged at least in portions between the first contact portion (25) and the first contact surface (11 / 45), the second metal layer (52) being arranged at least in portions between the second contact portion (35) and the second contact surface (12 / 46); the first connecting portion (26) of the first heat conducting body being opposite the second connecting portion (36) of the second heat conducting body, remote from the semiconductor component arrangement (10 / 40), and the joining agent (55) being arranged at least in portions between the first connecting portion (26) and the second connecting portion (36),
c) generating at least one force (53) which is effectively oriented, at least in components, from one of the two heat conducting bodies (20 / 30) in the direction of the other heat conducting body (30 / 20), and establishing an integral bond between the two heat conducting bodies (20, 30) by solidifying the joining agent (55), the temperature in step c) in the second metal layer (52) not exceeding the melting temperature of the metal material of the second metal layer (52) that has the lowest melting temperature, the at least one force (53) being generated at the same time as the integral bond is established in step c), and a force-closed connection being formed between the second contact portion (35) and the second contact surface (12 / 46) in method step c), which connection is maintained by the solidified joining agent (55).

2. Method according to claim 1, **characterized in that** the force (53) generated in method step c) is an external force which is applied externally to at least one of the heat conducting bodies (20 / 30) and is oriented, at least in components, in the direction of the other heat conducting body (30 / 20), the method step c) being followed by a method step d) in which the external force (53) is partially or completely released.

3. Method according to either of the preceding claims, **characterized in that** in method step b) an integral bond is produced between the first contact portion (25) and the semiconductor component arrangement (10 / 40), involving at least one metal material of the first metal layer (51) which is arranged between the first contact portion (25) and the semiconductor component arrangement (10 / 40).

4. Method according to any of the preceding claims, **characterized in that** a force-closed connection between the first contact portion (25) and the first contact surface (11 / 45) is also formed in method step c), which connection is maintained by the solidified joining agent (55).

5. Method according to any of claims 1 to 3, **characterized in that** in method step c) an integral bond is formed between the second contact portion (35) and the semiconductor component arrangement (10 / 40) by solid-state diffusion of at least one metal material of the second metal layer (52) into a metal surface region of the second contact portion (35) and/or of the second electrical terminal, and/or by solid-state diffusion of at least one metal material of the surface region of the second contact portion (35) and/or of the second electrical terminal into the second metal layer (52), without one of the metal materials of the second metal layer (52), the surface region of the second contact portion (35) or the second electrical terminal, one of the formed compounds thereof or one of the formed mixtures thereof with one another or with one or more of the formed compounds thereof transitioning into a liquid state.

6. Method according to any of claims 1 to 5, **characterized in that** in method step c) the temperature in the first metal layer (51) and the second metal layer (52) does not exceed the melting temperatures of the materials in the respective layers (51, 52) that have the lowest respective melting temperatures.

7. Method according to claim 6, **characterized in that** in method step c) an integral bond is formed between the second contact portion (35) and the semiconductor component arrangement (10 / 40) by solid-state diffusion of at least one metal material of the second metal layer (52) into a metal surface region of the second contact portion (35) and/or of the second electrical terminal, and/or by solid-state diffusion of at least one metal material of the surface region of the second contact portion (35) and/or of the second electrical terminal into the second metal layer (52), without one of the metal materials of the second metal layer (52), the surface region of the second contact portion (35) or the second electrical terminal, one of the formed compounds thereof or one of the formed mixtures thereof with one another or with one or more of the formed compounds thereof transitioning into a liquid state, and an integral bond is formed between the first contact portion (25) and the semiconductor component arrangement (10 / 40) by solid-state diffusion of at least one metal material of the first metal layer (51) into a metal surface region of the first contact portion (25) and/or of the first electrical terminal, and/or by solid-state diffusion of at least one metal material of the surface region of the first contact portion (25) and/or of the first electrical terminal into the first metal layer (51), without one of the metal materials of the first metal layer (52), the surface region of the first contact portion (25) or the first electrical terminal, one of the formed compounds thereof or one of the formed mixtures thereof with one another or with one or more of the formed compounds thereof transitioning into a liquid state.

8. Method according to any of the preceding claims, **characterized in that** at least method step c) takes place in vacuo or in a chemically inert or reducing atmosphere with respect to the first and/or second metal material of the first and/or second metal layer (51, 52), and/or **characterized in that** the first and the second heat conducting body (20, 30) consist of at least one metal-containing material, and the joining agent (55) is an electrically insulating joining agent from the group of thermosets and cements.

9. Method according to any of the preceding claims, **characterized in that** in method step a) or b) the first metal layer (51) is applied to the first contact surface (11 / 45) or to a first heat input surface (21) of the first contact portion (25) that faces the semiconductor component arrangement (10 / 40), and/or the second metal layer (52) is applied to the second contact surface (12 / 46) or to a second heat input surface (31) of the second contact portion (35) that faces the semiconductor component arrangement (10 / 40).

10. Method according to any of the preceding claims, **characterized in that** at least one material of the first and/or second metal layer (51, 52) contains a chemical element from the group of indium, tin, lead and cadmium, the first and/or second metal layer (51, 52) preferably consisting predominantly of indium with respect to weight, atomic and/or volume fractions, and the temperature of the first and/or second metal layer (51, 52) being at least temporarily greater than 30°C during the method step c).

11. Method according to any of the preceding claims, **characterized in that** the semiconductor component arrangement (10) is designed as a semiconductor component (10), and the electrical terminals are formed by at least one first electrically conductive contact layer (17) on the first face of the semiconductor component (10) and at least one second electrically conductive contact layer (18) on the second face of the semiconductor component (10), the first contact surface (11) being arranged on the face of the first electrically conductive contact layer (17) that faces away from the semiconductor component (10), and the second contact surface (12) being arranged on the face of the second electrically conductive contact layer (18) that faces away from the semiconductor component (10).

12. Method according to any of claims 1 to 11, **characterized in that** the semiconductor component arrangement (40) has at least one semiconductor component (10), the first electrical terminal (41) is designed as at least one first electrically conductive contact body (41) which is attached by integral bond to a first face of the semiconductor component (10) by means of a first electrically conductive joining agent, and the second electrical terminal (42) is designed as a second electrically conductive contact body (42) which is attached by integral bond to a second face of the semiconductor component (10) that is opposite the first face of the semiconductor component (10) by means of a second electrically conductive joining agent, the first and/or the second electrically conductive joining agent preferably containing gold and tin, and the first and/or second electrically conductive contact body (41, 42) preferably containing tungsten, molybdenum, carbon, boron nitride and/or silicon carbide.

13. Method according to either claim 11 or claim 12, **characterized in that** the first and the second heat conducting body (20, 30) predominantly consist of copper and/or aluminum with respect to weight, atomic and/or volume fractions.

14. Method according to any of the preceding claims, **characterized in that** the first heat conducting body (20) and/or the second heat conducting body (30) is/are a heat sink, and/or **characterized in that** the first heat conducting body (20) and/or the second heat conducting body (30) is/are connected to at least one heat sink.

## Revendications

1. Procédé de fabrication d'un module semi-conducteur (80), **caractérisé par** les étapes suivantes :
a) réalisation
i) d'un agencement de dispositifs semi-conducteurs (10/40) qui comporte
- au moins une première borne électrique présentant une première surface de contact (11/45) sur un premier côté, et
- au moins une seconde borne électrique présentant une seconde surface de contact (12/46) sur un second côté opposé au premier côté,
ii) un premier corps conducteur de chaleur (20) présentant une première partie de contact (25) et une première partie de connexion (26),
iii) au moins un second corps conducteur de chaleur (30) présentant une seconde partie de contact (35) et une seconde partie de connexion (36),
iv) une première couche métallique (51),
v) au moins une seconde couche métallique (52), et
vi) au moins un moyen d'assemblage (55) ;
b) mise en place de l'agencement de dispositifs semi-conducteurs (10/40) entre le premier et le second corps conducteur de chaleur (20, 30) de sorte que la première partie de contact (25) du premier corps conducteur de chaleur (20) fait face à la première surface de contact (11/45) et que la seconde partie de contact (35) du second corps conducteur de chaleur (30) fait face à la seconde surface de contact (12/46), la première couche métallique (51) étant disposée au moins partiellement entre la première section de contact (25) et la première surface de contact (11/45), la seconde couche métallique (52) étant disposée au moins partiellement entre la seconde partie de contact (35) et la seconde surface de contact (12/46) ; la première partie de connexion (26) du premier corps conducteur de chaleur étant opposée à la seconde partie de connexion (36) du second corps conducteur de chaleur loin de l'agencement de dispositifs semi-conducteurs (10/40), et le moyen d'assemblage (55) étant disposé au moins partiellement entre la première partie de connexion (26) et la seconde partie de connexion (36),
c) génération d'au moins une force (53) qui est orientée au moins composant par composant de manière effective à partir de l'un des deux corps conducteurs de chaleur (20/30) en direction de l'autre corps conducteur de chaleur (30/20), et établissement d'une liaison par correspondance de matière des deux corps conducteurs de chaleur (20, 30) par renforcement des moyens d'assemblage (55), la température dans la seconde couche métallique (52), à l'étape c) ne dépassant pas la température de fusion de ce matériau métallique de la seconde couche métallique (52), lequel matériau présente la température de fusion la plus basse, la génération de l'au moins une force (53) à l'étape c) se produisant en même temps que l'établissement d'une liaison par correspondance de matière, et une liaison par force étant réalisée entre la seconde partie de contact (35) et la seconde surface de contact (12/46) à l'étape de procédé c), laquelle liaison est maintenue par le moyen d'assemblage solidifié (55).

2. Procédé selon la revendication 1, **caractérisé en ce que** la force (53) générée à l'étape de procédé c) est une force externe qui est appliquée depuis l'extérieur sur au moins l'un des corps conducteurs de chaleur (20/30) et est orientée au moins composant par composant dans la direction de l'autre corps conducteur de chaleur (30/20), l'étape de procédé c) étant suivie d'une étape de procédé d) dans laquelle la force externe (53) est partiellement ou entièrement enlevée / abandonnée.

3. Procédé selon l'une des revendications précédentes, **caractérisé en ce que**, à l'étape de procédé b), une liaison par correspondance de matière est réalisée entre la première partie de contact (25) et l'agencement de dispositifs semi-conducteurs (10/40), avec intervention d'au moins un matériau métallique de la première couche métallique (51) disposée entre la première partie de contact (25) et l'agencement de dispositifs semi-conducteurs (10/40).

4. Procédé selon l'une des revendications précédentes, **caractérisé en ce que**, à l'étape de procédé c), une liaison par force est en outre réalisée entre la première partie de contact (25) et la première surface de contact (11/45), laquelle liaison est maintenue par le moyen d'assemblage solidifié (55).

5. Procédé selon l'une des revendications 1 à 3, **caractérisé en ce que**, à l'étape de procédé c), une liaison par correspondance de matière est réalisée entre la seconde partie de contact (35) et l'agencement de dispositifs semi-conducteurs (10/40), par diffusion à l'état solide d'au moins un matériau métallique de la seconde couche métallique (52) dans une région superficielle métallique de la seconde partie de contact (35) et/ou de la seconde borne électrique et/ou par diffusion à l'état solide d'au moins un matériau métallique de la région superficielle dans la seconde partie de contact (35) et/ou de la seconde borne électrique dans la seconde couche métallique (52), sans que l'un des matériaux métalliques de la seconde couche métallique (52), de la région superficielle de la seconde partie de contact (35) ou de la seconde borne électrique, l'une de leurs connexions ou l'un de leurs mélanges formés ne passent à un état liquide entre eux ou avec l'une ou plusieurs de ses connexions formées.

6. Procédé selon l'une des revendications 1 à 5, **caractérisé en ce que**, à l'étape de procédé c), la température dans la première couche métallique (51) et la seconde couche métallique (52) ne dépasse pas les températures de fusion de ces matériaux dans les couches respectives (51, 52) ayant les températures de fusion respectivement les plus basses.

7. Procédé selon la revendication 6, **caractérisé en ce que**, à l'étape de procédé c) une liaison par correspondance de matière est réalisée entre la seconde partie de contact (35) et l'agencement de dispositifs semi-conducteurs (10/40) par diffusion à l'état solide d'au moins un matériau métallique de la seconde couche métallique (52) dans une région superficielle métallique de la seconde partie de contact (35) et/ou de la seconde borne électrique et/ou par diffusion à l'état solide d'au moins un matériau métallique de la région superficielle de la seconde partie de contact (35) et/ou de la seconde borne électrique de la seconde couche métallique (52), sans que sans que l'un des matériaux métalliques de la seconde couche métallique (52), de la région superficielle de la seconde partie de contact (35) ou de la seconde borne électrique, l'une de leurs connexions ou l'un de leurs mélanges formés ne passent à un état liquide entre eux ou avec l'une ou plusieurs de ses connexions formées, et
une liaison par correspondance de matière est réalisée entre la première partie de contact (25) et l'agencement de dispositifs semi-conducteurs (10/40) par diffusion à l'état solide d'au moins un matériau métallique de la première couche métallique (51) dans une région superficielle métallique de la première partie de contact (25) et/ou de la première borne électrique et/ou par diffusion à l'état solide d'au moins un matériau métallique de la région superficielle de la première partie de contact (25) et/ou de la première borne électrique dans la première couche métallique (51), sans que l'un des matériaux métalliques de la seconde couche métallique (52), de la région superficielle de la seconde partie de contact (25) ou de la seconde borne électrique, l'une de leurs connexions ou l'un de leurs mélanges formés ne passent à un état liquide entre eux ou avec l'une ou plusieurs de ses connexions formées.

8. Procédé selon l'une des revendications précédentes, **caractérisé en ce qu'**au moins l'étape de procédé c) se déroule sous vide ou dans une atmosphère chimiquement inerte ou réductrice par rapport au premier et/ou au second matériau métallique de la première et/ou de la seconde couche métallique (51, 52), et/ou **caractérisé en ce que** le premier et le second corps conducteur de chaleur (20, 30) se composent d'au moins un matériau métallique, et **en ce que** le moyen d'assemblage (55) est un moyen d'assemblage électriquement isolant du groupe des duroplastes et ciments.

9. Procédé selon l'une des revendications précédentes, **caractérisé en ce que**, à l'étape de procédé a) ou b), la première couche métallique (51) est appliquée sur la première surface de contact (11/45) ou une première surface d'entrée de chaleur (21) de la première partie de contact (25) tournée vers l'agencement de dispositifs semi-conducteurs (10/40) et/ou la seconde couche métallique (52) est appliquée sur la seconde surface de contact (12/46) ou une seconde surface d'entrée de chaleur (31) de la seconde partie de contact (35) tournée vers l'agencement de dispositifs semi-conducteurs (10/40).

10. Procédé selon l'une des revendications précédentes, **caractérisé en ce qu'**au moins un matériau de la première et/ou de la seconde couche métallique (51, 52) contient un élément chimique du groupe constitué par l'indium, l'étain, le plomb et le cadmium, la première et/ou la seconde couche métallique (51, 52) étant de préférence constituée principalement d'indium en termes de poids, d'atomes et/ou de volume, et **en ce que** la température de la première et/ou seconde couche métallique (51, 52) est au moins temporairement supérieure à 30 °C pendant l'étape c).

11. Procédé selon l'une des revendications précédentes, **caractérisé en ce que** l'agencement de dispositifs semi-conducteurs (10) est conçu sous la forme de dispositif semi-conducteur (10), et **en ce que** les bornes électriques sont formées par au moins une première couche de contact électriquement conductrice (17) sur le premier côté du dispositif semi-conducteur (10) et au moins une seconde couche de contact électriquement conductrice (18) sur le second côté du dispositif semi-conducteur (10), la première surface de contact (11) étant disposée sur le côté opposé au dispositif semi-conducteur (10) de la première couche de contact électriquement conductrice (17), et la seconde surface de contact (12) étant disposée sur le côté de la seconde couche de contact conductrice (18) opposé au dispositif semi-conducteur (10).

12. Procédé selon l'une des revendications 1 à 11, **caractérisé en ce que** l'agencement de dispositifs semi-conducteurs (40) comporte au moins un dispositif semi-conducteur (10), la première borne électrique (41) étant conçue sous la forme d'au moins un premier corps de contact électriquement conducteur (41) qui est relié par correspondance de matière à un premier côté du dispositif semi-conducteur (10) au moyen d'un premier moyen d'assemblage électriquement conducteur, et la seconde borne électrique (42) est conçue sous la forme d'un second corps de contact électriquement conducteur (42) relié par correspondance de matière au moyen d'un second moyen d'assemblage électriquement conducteur à un second côté du dispositif semi-conducteur (10) opposé au premier côté du dispositif semi-conducteur (10), le premier et/ou le second moyen d'assemblage électriquement conducteur contenant de préférence de l'or et de l'étain et le premier et/ou le second corps de contact électriquement conducteur (41, 42) contenant du tungstène, du molybdène, du carbone, du nitrure de bore et/ou du carbure de silicium.

13. Procédé selon la revendication 11 ou 12, **caractérisé en ce que** le premier et le second corps conducteur de chaleur (20, 30) sont constitués principalement de cuivre et/ou d'aluminium en termes de poids, d'atomes et/ou de volume.

14. Procédé selon l'une des revendications précédentes, **caractérisé en ce que** le premier corps conducteur de chaleur (20) et/ou le second corps conducteur de chaleur (30) est ou sont un dissipateur thermique, et/ou **caractérisé en ce que** le premier corps conducteur de chaleur (20) et/ou le second corps conducteur de chaleur (30) est ou sont reliés à au moins un dissipateur thermique.
